# EUROPEAN PATENT SPECIFICATION

(11) **EP 0 737 546 B1**
(45) Date of publication and mention of the grant of the patent: **28.02.2001**
(21) Application number: 96105657.9
(22) Date of filing: 10.04.1996
(51) Int. Cl.: B24B 37/04, B24B 57/02

(54) **Apparatus for holding substrate to be polished and apparatus and method for polishing substrate**
Haltevorrichtung für ein Substrat und Verfahren und Vorrichtung zum Polieren eines Substrates
Dispositif pour tenir un substrat à polir et procédé et appareil pour polir un substrat

(30) Priority: 10.04.1995 JP 8386095; 08.06.1995 JP 14153695; 30.11.1995 JP 31297895
(43) Date of publication of application: 16.10.1996
(73) Proprietor: MATSUSHITA ELECTRIC INDUSTRIAL CO., LTD., Kadoma-shi, Osaka-fu 571-8501 (JP)
(72) Inventor: Nishio, Mikio, Moriguchi-shi, Osaka 570 (JP)
(74) Representative: Grünecker, Kinkeldey, Stockmair & Schwanhäusser Anwaltssozietät

(56) References cited:
- EP-A- 0 623 423
- WO-A-94/07110
- DE-U- 8 631 087
- RESEARCH DISCLOSURE, no. 322, 1 February 1991, page 95 XP000168310 "PRESSURIZED WAFER HOLDER FOR UNIFORM POLISHING"
- PATENT ABSTRACTS OF JAPAN vol. 014, no. 570 (M-1060), 18 December 1990 & JP-A-02 243263 (HITACHI LTD), 27 September 1990,
- PATENT ABSTRACTS OF JAPAN vol. 018, no. 421 (C-1234), 8 August 1994 & JP-A-06 125768 (TAX ADM AGENCY;OTHERS: 01), 10 May 1994,
- DATABASE WPI Week 7851 Derwent Publications Ltd., London, GB; AN 78-92273a XP002019835 & JP-A-53 131 595 (KANSAI ET AL.) , 16 November 1978

## Description

The present invention relates to a method of polishing a substrate whereby chemical mechanical polishing (CMP) is performed with respect to a semiconductor substrate of silicon or a liquid-crystal substrate to flatten a surface thereof, to an apparatus for polishing a substrate, and to an apparatus for holding a substrate to be polished by the above method of polishing a substrate.

From the 1990s, as semiconductor and liquid-crystal substrates processed by CMP technology have had larger diameters on the order of 10 cm or more, there have been increasing tendencies toward single-wafer polishing. In the case of polishing a semiconductor substrate, in particular, equal polishing should be performed with respect to the entire surface thereof since a design rule of 0.5 µm or less has been used to define extremely small lines and spaces on the semiconductor substrate.

Below, a method and apparatus for polishing a substrate according to a first conventional embodiment will be described with reference to the drawings.

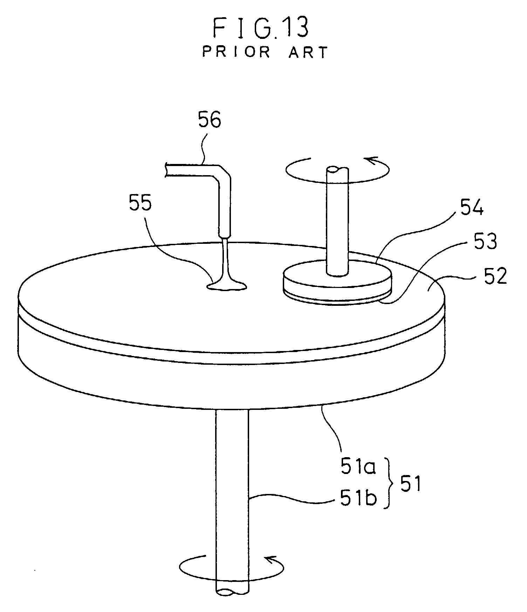

FIG. 13 schematically shows the structure of the apparatus for polishing a substrate according to the first conventional embodiment, in which is shown a table 51 including: a pad table 51a having a flat surface which is made of a rigid material; a rotary shaft 51b extending downwardly from the back face of the pad table 51a; and rotating means (not shown) for rotating the rotary shaft 51b. To the top surface of the pad table 51a of the table 51 is adhered an elastic polishing pad 52. Above the polishing pad 52 is provided a substrate holding head 54 which holds and rotates a substrate 53. The substrate 53 is pressed against the polishing pad 52 while being rotated by the substrate holding head 54. An abrasive agent 55 in a prescribed amount is supplied dropwise from an abrasive supply pipe 56 onto the polishing pad 52.

In the apparatus for polishing a substrate thus constituted, the polishing pad 52 supplied with the abrasive agent 55 is rotated by rotating the table 51 and the substrate 53 held by the substrate holding head 54 is pressed against the rotating polishing pad 52 so that a surface of the substrate 53 is polished under pressure and at a relative speed.

In this process, if the surface of the substrate 53 being polished is rugged, projecting portions thereof are removed at an increased relative polishing rate since their contact pressure with the polishing pad 52 is high. On the other hand, recessed portions thereof are barely polished since their contact pressure with the polishing pad 52 is low. Consequently, the surface of the substrate 53 to be polished becomes less rugged and more smooth.

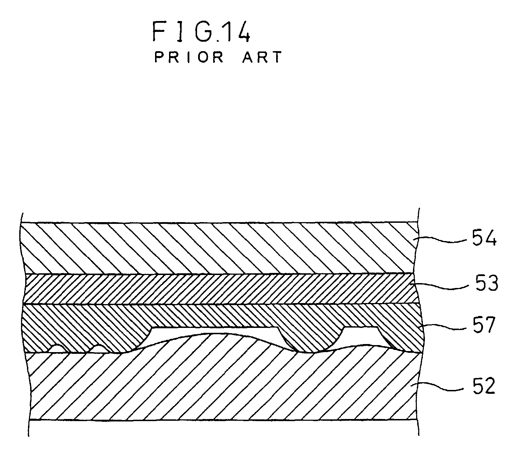

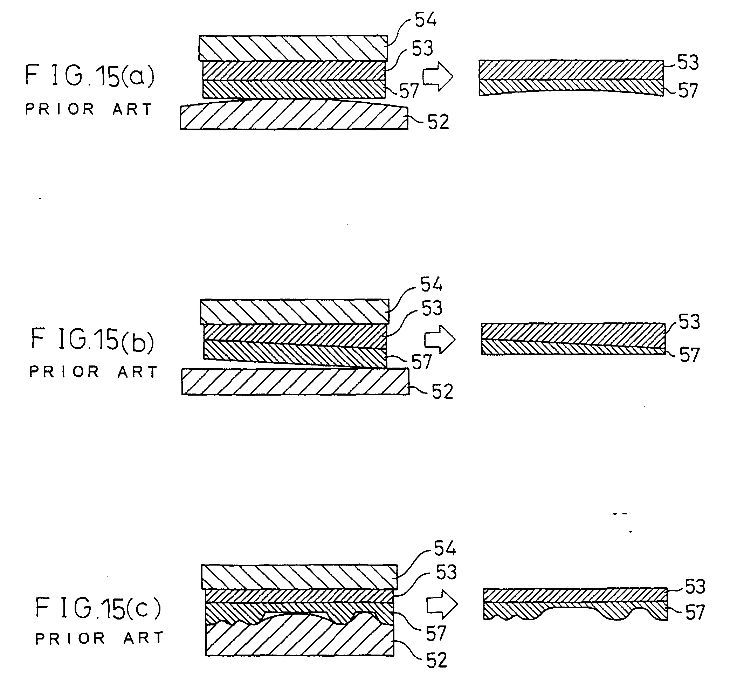

However, the first conventional embodiment mentioned above presents the following problems, which will be described below with reference to FIG. 14 and FIGS. 15(a) to 15(c).

FIG. 14 is a schematic view illustrating a polishing method implemented by the above first conventional embodiment. FIGS. 15(a) to 15(c) are schematic views elucidating the problems of the first conventional embodiment. By way of example, a description will be given to a problem in polishing an oxide film 57 having a rugged surface which is formed on the substrate 53 of silicon.

As described above, when the substrate 53 held by the substrate holding head 54 is pressed against the polishing pad 52 as shown in FIG. 14, the projecting portions of the oxide film 57 are removed since their contact pressure with the polishing pad 52 is high, while the recessed portions thereof are barely polished since their contact pressure with the polishing pad 52 is low, resulting in a flat surface of the oxide film 57 with a reduced degree of ruggedness.

In this process, the substrate 53 held by the substrate holding head 54 is pressed against the polishing pad 52 with an equal force. However, if the pad table 51a of the table 51 has a warped surface and the polishing pad 52 is elastically deformed as shown in the left part of FIG. 15(a) or if the thickness of the substrate 53 has variations as shown in the left part of FIG. 15(b), the contact pressure between the oxide film 57 and the polishing pad 52 is not equal but differs from one portion to another even when the substrate 53 is pressed against the polishing pad 52 with an equal force. As a result, the polishing rate is higher at portions under higher contact pressure (these portions of the oxide film 57 which are in contact with the projecting portions of the pad table 51a or polishing pad 52 and which correspond to thicker portions of the substrate 53), while the polishing rate is lower at portions under lower contact pressure (these portions of the oxide film 57 which are in contact with the recessed portions of the pad table 51a or polishing pad 52 and which correspond to thinner portions of the substrate 53), resulting in an unequal amount of polishing with respect to the oxide film 57.

To overcome the problem, it is possible to lessen variations in contact pressure resulting from the ruggedness of the pad table 51a or polishing pad 52 or from varied thickness of the substrate 53 by increasing the ease with which the polishing pad 52 is elastically deformed in accordance with the ruggedness of the pad table 51a or polishing pad 52 or with varied thickness of the substrate 53, thereby achieving an equal contact pressure. However, when the polishing pad 52 is softened, it is deformed in accordance with the rugged configuration of the oxide film 57, so that even the recessed portions of the oxide film 57 are brought into contact with the polishing pad 52 and undergo polishing. Accordingly, variations in level on the surface of the oxide film 47 cannot be lessened as shown in the right part of FIG. 15(c).

To overcome the problem, there has been proposed a technique which utilizes the deformation of the substrate 63 against the elastic deformation of the polishing pad 62.

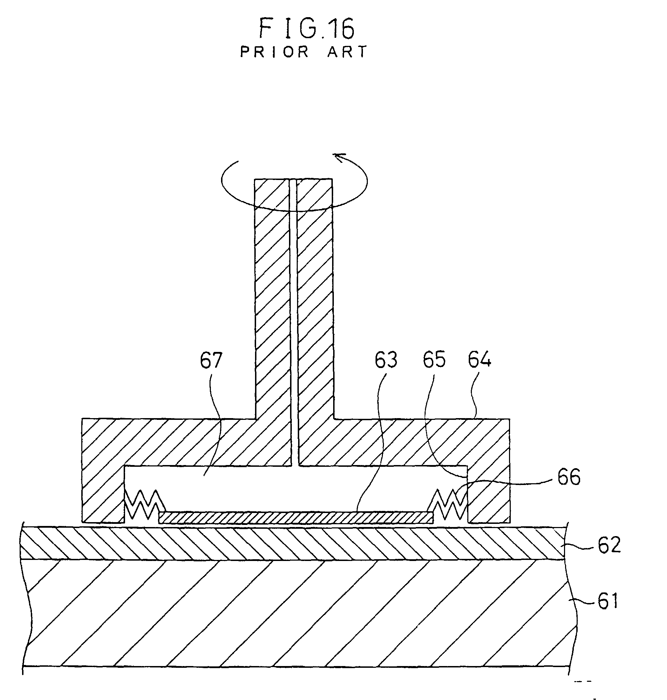

FIG. 16 shows a method and apparatus for polishing a substrate according to a second conventional embodiment, wherein an elastic polishing pad 62 is adhered to the top surface of a table 61. The bottom portion of a substrate holding head 64 for holding a substrate 63 is formed with a recessed portion 65. The substrate 63 is solidly supported by a plate-like elastic member 66 which can be elastically deformed in the recessed portion 65 of the substrate 63. The substrate holding head 64, elastic member 66, and substrate 63 define a hermetically sealed space 67 into which a gas under controlled pressure is introduced through a gas supply path 68. The gas under pressure introduced into the hermetically sealed space 67 presses the substrate 63 solidly supported by the elastic member 66 against the polishing pad 62, so that the pressure on the upper face of the substrate 63 achieves equal polishing.

However, since the second conventional embodiment is so constituted that the substrate 63 is solidly supported by the plate-like elastic member 66, there arises a first problem of a complicated mechanism and intricate operation of mounting and dismounting the substrate 63.

In the foregoing first conventional embodiment, on the other hand, the polishing pad 52 have different thicknesses from one portion to another due to elastic deformation caused by pressure during polishing or loading is caused by abrasive grains which have been jammed into the surface of the polishing pad 52, so that the surface state of the polishing pad 52 changes and the polishing rate varies. Moreover, a friction between the substrate 53 and the polishing pad 52 causes partial abrasion of the polishing pad 52 or the polishing pad 52 itself is thinned since the polishing pad 52 elastically deformed under pressure during polishing is not restored.

Consequently, the surface of the polishing pad 52 becomes rugged due to varied thickness of the polishing pad 52 so that variations in pressure are produced over the surface of the substrate 53 even if the substrate 53 is pressed against the polishing pad 52 with an equal force, resulting in an unequal amount of polishing with respect to the surface of the substrate.

To avoid an unequal amount of polishing due to a change (fatigue) in the surface state of the polishing pad 52, a dressing process is performed with respect to the polishing pad 52, in which projecting portions are removed from the surface of the polishing pad 52 or the loading is eliminated to maintain the polishing pad 52 in a constant state and thereby accomplish equal polishing with respect to the surface of the substrate 53.

However, the method in which the dressing process is performed with respect to the polishing pad has the following problems.

First, to impart constant flatness to the surface of the polishing pad which undergoes changes caused by abrasion or the like during polishing, it is necessary to control the amount of removal from the polishing pad based on the height and depth of projecting and recessed portions formed during polishing. However, it is extremely difficult to measure the height and depth of the projecting and recessed portions and control the amount of removal since the height and depth of the projecting and recessed portion from the surface level of the polishing pad is as small as several micrometers to several tens of micrometers. In particular, it is extremely difficult to polish the surface of the substrate with such an accuracy as is required in the latest device manufacturing process.

Second, since the removal from the polishing pad by the dressing process reduces the thickness of the polishing pad, the elasticity of the polishing pad changes and the ability to absorb variations in pressure on the surface of the substrate differs from one dressing process to another, so that steady polishing characteristics (surface uniformity and the ability to tolerate variations in level) cannot be obtained.

Third, although it is required to replace polishing pads which are sufficiently thick to implement the polishing characteristics, the replacing operation should be performed manually.

Fourth, although the above first problem can be overcome to a certain extent if variations in pressure on the surface of the substrate is absorbed by the use of a polishing pad which is liable to elastic deformation, the ability to tolerate variations in the level of the substrate is lowered by the use of the polishing pad which is liable to elastic deformation.

Fifth, although the thickness of the polishing pad adhered to the table is measured mechanically, it is difficult to measure the thickness of the polishing pad soaked with an abrasive agent or cleaning water. Moreover, in the case where a sequence of polishing processes are performed on end, it is impossible to measure the thickness of the polishing pad. Furthermore, when measured mechanically, the thickness of the polishing pad can only be estimated empirically based on the amount of polishing and on the amount of abrasion of the polishing pad for such reasons that the distribution of thickness over the surface of the polishing pad cannot be estimated unless measurements are performed at a large number of points and that high-accuracy measurements cannot be performed since the measurement accuracy in a microgage normally used is on the order of 10 µm, though the surface of the polishing pad is formed with projecting and recessed portions which are about several micrometers in height and depth.

An apparatus for holding a substrate to be polished and pressing the held substrate against a polishing pad, having the features of the preamble of claim 1 or claim 2 is known from "Research Disclosure", no. 322, February 1991, page 95: "Pressurized Wafer Holder for Uniform Polishing".

In view of the foregoing, a first object of the present invention is to enable equal polishing with respect to a substrate even when a table or polishing pad is rugged or the thickness of the substrate varies from one portion to another, while facilitating the mechanism and operation of mounting and dismounting the substrate.

This object is achieved with an apparatus having the features of claim 1 or claim 2 and a method having the features of claim 6 or claim 9.

In the first apparatus for holding a substrate to be polished in accordance with claim 1, since the substrate holding head has the substrate attracting means, the substrate can be attracted and held by suction such that it is conveyed to a position above the polishing pad.

Moreover, since an annular sealing member is provided to define the space in conjunction with the substrate holding head and the substrate disposed on the polishing pad, while the substrate holding head has a fluid supply path through which the fluid under pressure flows out, the substrate can be pressed against the polishing pad under the pressure of the fluid supplied to the space. In this case, since the height and depth of projecting and recesses portions from the surface level of the polishing pad or of the table can easily be restricted to typically several hundreds of micrometers or less, the substrate can be deformed in accordance with the rugged configuration of the polishing pad with a significantly small pressing force, so that the contact pressure between the substrate and the polishing pad becomes equal even when a hard polishing pad is used.

Furthermore, since the substrate holding head and the annular sealing member do not solidly support the substrate to be polished, if the pressure of the fluid supplied to the space exceeds the pressing force applied to the substrate holding head, the fluid pushes up the sealing member and the substrate holding head and flows to the outside through the clearance between the sealing member and the substrate, so that the pressure exerted on the substrate by the fluid becomes substantially equal to the pressing force applied to the substrate holding head in a spontaneous manner. Consequently, the substrate is pressed against the polishing pad with a steady pressing force.

With the second apparatus for holding a substrate to be polished according to claim 2, the substrate can be attracted and held by suction such that it is conveyed to a position above the polishing pad, similarly to the first apparatus for holding a substrate to be polished. In addition, the substrate can be pressed against the polishing pad under the pressure of the fluid supplied to the space.

Thus, with the first and second apparatus for holding a substrate to be polished, since the substrate can be attracted and held by suction such that it is conveyed to a position above the polishing pad, the mounting and dismounting of the substrate and the conveyance thereof can be implemented easily and reliably with a simple structure. Moreover, since the substrate can be pressed against the polishing pad under the pressure of the fluid supplied to the space defined by the substrate holding head, the annular sealing member, and the substrate disposed on the polishing pad, the pressure exerted on the substrate to press it against the polishing pad is steady and equal even when the polishing pad is rugged, the substrate is deformed, or foreign substances such as particles are attached to the upper face of the substrate, resulting in equal polishing with respect to the substrate.

In the second apparatus for holding a substrate to be polished, the above annular sealing member is provided so as to move toward the substrate and press a peripheral portion of the substrate against the above polishing pad during polishing. With the arrangement, there can be avoided the floating of the peripheral portion of the substrate during polishing.

In this case, the above sealing member is provided so as to press the peripheral portion of the substrate against the above polishing pad when the pressure of the fluid supplied from the other end of the above fluid supply path to the above space is exerted thereon. With the arrangement, the peripheral portion of the substrate can be pressed against the polishing pad under the same pressure as exerted on the other portion thereof, so that the substrate can be polished more equally.

Preferable embodiments are the subject matter of the respective dependent claims.

The first or second apparatus for holding a substrate to be polished further comprises a guiding member provided on the above substrate holding head to be located outside the above sealing member, the above guiding member holding the substrate disposed on the above polishing pad in a given position. With the arrangements, the substrate disposed on the polishing pad can be held positively in a given position.

Preferably, the first or second apparatus for holding a substrate to be polished further comprises means for causing the fluid under pressure supplied to the above space to flow to an outside of the above space.

With the arrangement, even when the pressure of the fluid supplied to the space exceeds the pressing force applied to the substrate holding head and therefore the polishing pad is elastically deformed or an abrasive agent flows into the clearance between the guiding member and the polishing pad. the fluid smoothly flows to the outside, so that the fluid is prevented from flowing into the clearance between the substrate and the polishing pad and pushing up the substrate.

In the first and second apparatus for holding a substrate to be polished, it is preferable that the above guiding member has a connecting path between an inside and an outside thereof. With the arrangement, the space can be defined by the substrate holding head, the guiding member, and the substrate, so that the substrate can be pressed equally by the fluid supplied to the space. In the case where the pressure of the fluid becomes excessively large in the space, the fluid is allowed to flow to the outside through the connecting path.

In the first and second apparatus for holding a substrate to be polished, it is preferable that a portion of the above substrate holding head in which the other end of the above fluid supply path is opened is formed as a flat surface, the above apparatus further comprising means for setting a distance between the above flat surface and the substrate disposed on the above polishing pad to a value equal to or larger than 1/1000 of a diameter of the substrate. With the arrangement, there can be avoided the production of a resistance to the flow of the fluid passing through the clearance between the substrate and the substrate holding head and hence variations in the pressure of the fluid for pressing the substrate, so that the substrate can be polished more equally.

In the first method of polishing a substrate, the first step includes the step of supplying the fluid under pressure to a space defined by the above substrate holding head, an annular sealing member fastened to the above substrate holding head, and the substrate disposed on the above polishing pad. With the arrangement, the substrate can be pressed against the polishing pad by the fluid supplied to the above space, resulting in more equal polishing with respect to the substrate.

Preferable embodiments of the first method are the subject matter of the respective subclaims.

In the first method of polishing a substrate, the above step preferably includes the step of pressing the above substrate holding head against the above polishing pad with a given pressing force and a pressure per unit area of the fluid supplied to the above space is preferably larger than a pressure obtained by dividing the above given pressing force by an area of a surface of the substrate to be polished. With the arrangement, the fluid presses the substrate to be polished while flowing from the space to the outside, so that variations in the pressure of the fluid acting on the substrate are reduced, resulting in more equal polishing with respect to the substrate.

In this case, the pressure per unit area of the fluid supplied to the above space is preferably any value in a range of 1.1 to 2.2 times the pressure obtained by dividing the above given pressing force by the area of the surface of the substrate to be polished. With the arrangement, the flow velocity of the fluid is prevented from becoming excessively small because the fluid barely flows out of the space. Conversely, the flow velocity of the fluid is prevented from becoming excessively large because an excessive amount of fluid has flown out of the space. Consequently, variations in the pressure of the fluid are further reduced, resulting in more equal polishing with respect to the substrate.

In the first method of polishing a substrate, an annular guiding member for holding the substrate disposed on the above polishing pad in a given position is provided on the above substrate holding head to be located outside the above sealing member, the above third step preferably includes the step of pressing the above substrate holding head against the above polishing pad with a given pressing force, and a pressure per unit area of the fluid supplied to the above space is preferably smaller than a pressure obtained by dividing the above given pressing force by an area of a surface of the substrate to be polished. With the arrangement, the fluid is prevented from flowing into the clearance between the substrate and the polishing head and lifting the substrate and the sealing member which can be brought in contact and apart from the substrate holding head.

In this case, the pressure per unit area of the fluid supplied to the above space is preferably less than a pressure obtained by dividing the above given pressing force by the area of the surface of the substrate to be polished. With the arrangement, there can be avoided the lifting of the sealing member and substrate resulting from an increase in the pressure of the fluid supplied to the space. On the other hand, since the pressing force applied to the substrate holding head does not become excessively large compared with the pressure of the fluid, the guiding member is prevented from being forcibly pressed against the polishing pad.

In the first method of polishing a substrate, the above substrate holding head is provided with an annular guiding member for holding the substrate disposed on the above polishing pad in a given position, the above first step preferably includes the step of holding the substrate by means of the above substrate holding head such that a surface of the substrate to be polished is positioned higher than a back face of the above guiding member, and the above third step preferably includes the step of moving the above substrate holding head to a position at which the surface of the substrate to be polished is substantially flush with the back face of the above guiding member. With the arrangement, the pressure exerted on the substrate by the fluid supplied to the space and the pressing force applied to the guiding member are substantially equalized, so that the substrate can be pressed against the polishing pad while the fluid supplied to the space is barely allowed to flow out of the space.

In the second method of polishing a substrate , there can be avoided the floating of the peripheral portion of the substrate during polishing.

In the first method of polishing a substrate, a portion of the above substrate holding head which holds the substrate is preferably formed as a flat surface and the third step preferably includes the step of maintaining a distance between the above flat surface and the substrate disposed on the above polishing pad at a value equal to or larger than 1/1000 of a diameter of the substrate. With the arrangement, there can be avoided the production of a resistance to the flow of the fluid passing through the clearance between the substrate and the substrate holding head and hence variations in the pressure of the fluid exerting pressure on the substrate, resulting in more equal polishing with respect to the substrate.

Thus, with the first and second apparatus for holding a substrate to be polished and by the first and second method of polishing a substrate, the substrate can be pressed against the polishing pad under steady pressure and polished steadily. Moreover, the substrate can be polished equally even when the polishing pad or the table on which the polishing pad is disposed is rugged and the thickness of the substrate varies from one portion to another. Furthermore, the mounting and dismounting of the substrate and the conveyance thereof can be implemented with a simple structure.
FIG. 1 is a schematic cross-sectional view of an apparatus for holding a substrate to be polished according to a first embodiment of the present invention;
FIGS. 2(a) and 2(b) are schematic views showing respective steps of a polishing method using the above apparatus for holding a substrate to be polished according to the first embodiment;
FIG. 3 is a schematic view illustrating operation in a polishing step of the polishing method using the above apparatus for holding a substrate to be polished according the first embodiment;
FIGS. 4(a) and 4(b) are bottom views of a guiding member in the above apparatus for holding a substrate to be polished according to the first embodiment;
FIG. 5 is a schematic cross-sectional view useful in understanding of the present invention and showing an apparatus for holding a substrate to be polished ;
FIGS. 6(a) and 6(b) are schematic views showing respective steps of a polishing method using the above apparatus for holding a substrate to be polished ;
FIG. 7 is a schematic cross-sectional view of an apparatus for holding a substrate to be polished according to a second embodiment of the present invention;
FIGS. 8(a) and 8(b) are schematic views showing respective steps of a polishing method using the above apparatus for holding a substrate to be polished according to the second embodiment;
FIG. 9 schematically shows the structure of an apparatus for polishing a substrate ;
FIG. 10 is a flow chart useful in understanding the present invention and showing the steps of a method of polishing a substrate ;
FIG. 11 schematically shows the structure of an apparatus for polishing a substrate ;
FIG. 12 shows a relationship between the thickness of a polishing pad used in the above method of polishing a substrate and signal intensities of colors;
FIG. 13 is a schematic perspective view of an apparatus for polishing a substrate according to a first conventional embodiment;
FIG. 14 is a schematic view illustrating a polishing method implemented by the above apparatus for polishing a substrate according to the first conventional embodiment;
FIGS. 15(a) to 15(c) are schematic views illustrating problems in the polishing method implemented by the above apparatus for polishing a substrate according to the first conventional embodiment; and
FIG. 16 is a schematic cross-sectional view of an apparatus for polishing a substrate according to a second conventional embodiment.

Below, an apparatus for holding a substrate to be polished and a method and apparatus for polishing a substrate according to each embodiment of the present invention will be described with reference to the drawings.

### (First Embodiment)

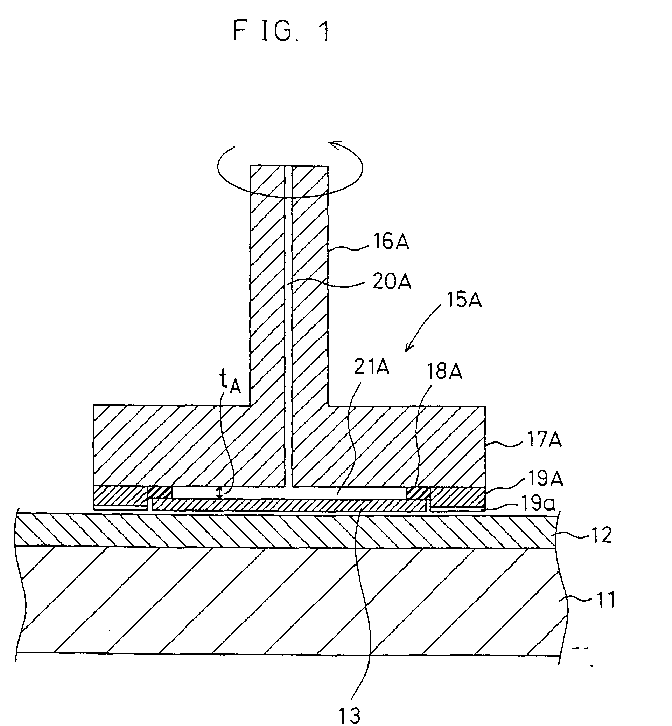

FIG. 1 is a schematic cross-sectional view of an apparatus for holding a substrate to be polished according to a first embodiment of the present invention, in which are shown: a rotatable table 11 having a flat surface which is made of a rigid material; and an elastic polishing pad 12 adhered to the top surface of the table 11.

Above the table 11 is provided a substrate holding apparatus 15A for holding a substrate 13, which comprises: a rotary shaft 16A rotated by rotary driving means (not shown); a substrate holding head 17A in the form of a disc which is provided integrally on the lower edge of the rotary shaft 16A; a sealing member 18A in the form of a ring which is made of an elastic material such as a silicon rubber and fastened to the peripheral portion of the back face of the substrate holding head 17A: a guiding member 19A in the form of a ring which is fastened to the back face of the substrate holding head 17A outside the sealing member 18A; and a fluid flow path 20A as a fluid supply path which allows a fluid under pressure introduced from one end thereof (upper end in FIG. 1) to flow out from the other end thereof (lower end in FIG. 1).

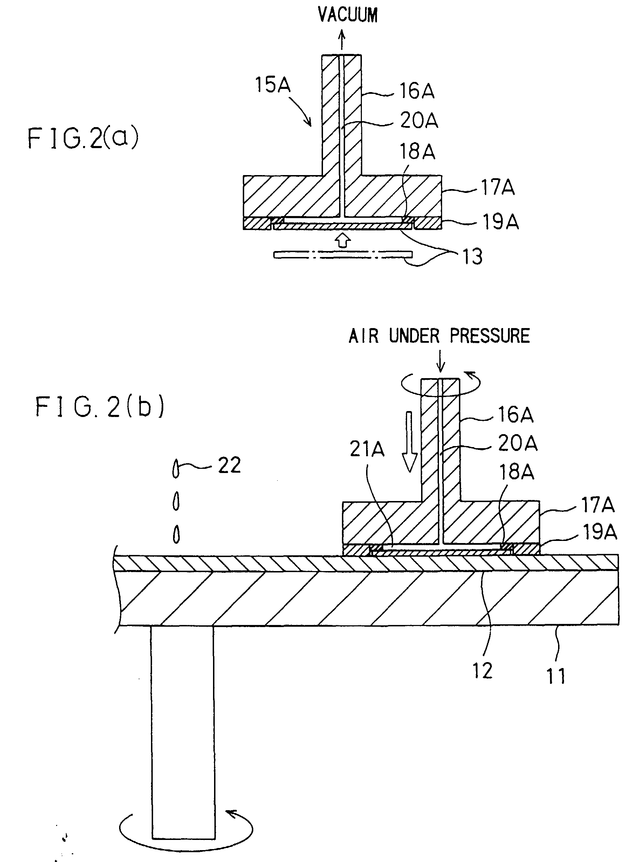

Below, a description will be given to a method of polishing a substrate implemented by means of the apparatus for holding a substrate to be polished according to the first embodiment with reference to FIGS. 2(a) and 2(b).

A description will be given first to operation during the conveyance of the substrate 13. The substrate 13 or substrate holding apparatus 15A is moved horizontally so that the substrate 13 is placed under the substrate holding head 17A. The substrate holding head 17A is then moved downward to be closer to the substrate 14. Subsequently, the atmosphere under the substrate holding head 17A is sucked through the fluid flow path 20A so that the substrate 13 is attracted and held by the substrate holding head 17A via the sealing member 18A, as shown in FIG. 2(a). The substrate holding head 17A holding the substrate 13 is conveyed horizontally to a position above the polishing pad 12 over the table 11. In this manner, the substrate 13 can be held and conveyed easily and positively.

Next, the structure of the apparatus for holding a substrate to be polished according to the first embodiment will be described in detail, while operation during polishing is described.

As shown in FIG. 2(b), an atmospheric pressure is achieved in the fluid flow path 20A to release the substrate 13, thereby placing the substrate 13 on the polishing pad 12, followed by the application of a downward force to the rotary shaft 16A. In the case of pressing the substrate 13 of silicon having a diameter of 8 inches against the polishing pad 12 under a pressure of 500 g/cm² so that the substrate 13 is polished, the pressing force applied to the rotary shaft 16A becomes 157 kg. In this case, a space 21A defined by the substrate holding head 17A, sealing member 18A, and substrate 13 is supplied with a fluid under pressure composed of, e.g., an air or nitrogen under pressure of 800 g/cm² through the fluid supply path 20A. Subsequently, the table 11 and the substrate holding head 17A are rotated relative to each other, while an abrasive agent 22 containing abrasive grains is supplied dropwise onto the polishing pad 12. Since the substrate 13 slides over the polishing pad 12 with its lower face kept in contact with the polishing pad 12, the polished face of the substrate 13 becomes less rugged and more smooth. The guiding member 19A prevents the substrate 13 from thrusting out due to a centrifugal force accompanying the rotation and holds it in a given position.

Here, a consideration will be given to the height t_{A} (see FIG. 1) of the space 21A. Although the fluid under pressure supplied to the space 21A through the fluid flow path 20A presses the substrate 13 from its upper face against the polishing pad 12, the fluid under pressure leaks out of the space 21A through the clearance between the substrate 13 and the sealing member 18A. If the height t_{A} of the space 21A is small, a resistance to the flow of the fluid under pressure is produced in the space 21A, which causes variations in pressure inside the space 21A, resulting in unequal pressing of the substrate 13. Hence, it is required to set the height t_{A} of the space 21A to a value which barely produces a pressure loss in the fluid under pressure flowing through the space 21A. The height t_{A} of the space 21A is determined by the thickness of the sealing member 18A. In the case of using a fluid with low viscosity such as water or air (nitrogen) as the fluid under pressure, variations in pressure are rarely observed inside the space 21A if the height t_{A} of the space 21A is set to a value equal to or larger than 1/1000, preferably a value equal to or larger than 2/1000, of a dimension of the substrate 13 (a diameter of a disc-shaped substrate 13 or a diagonal of a square substrate 13). Specifically, it is preferred to set the height t_{A} of the space 21A to 0.5 mm by using the sealing member 18A having a thickness of 0.5 mm.

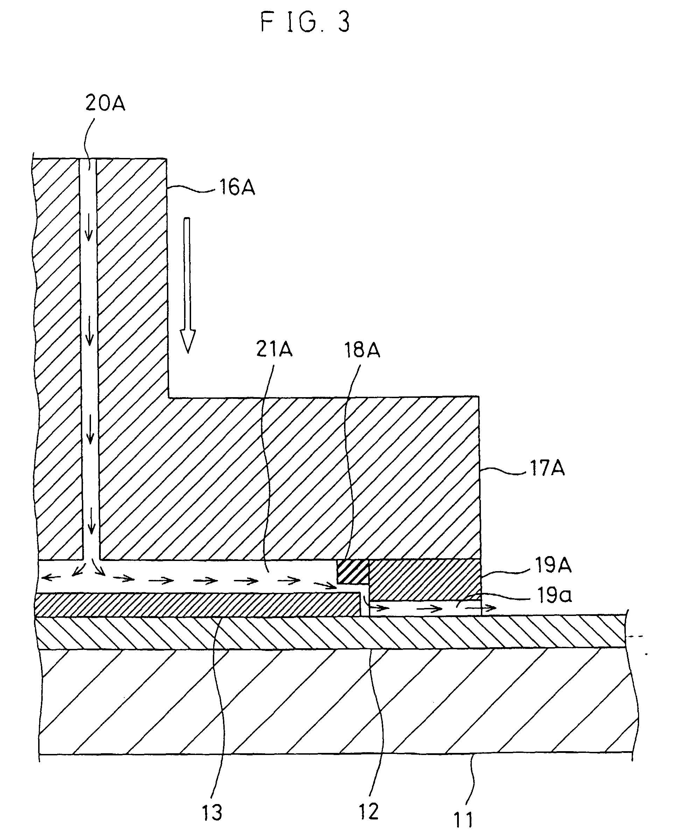

As described above, since the pressure of the fluid supplied to the space 21A through the fluid flow path 20A is larger than the pressing force applied to the rotary shaft 16A, if the distance between the substrate 13 and the guiding member 19A is set to about 0.1 mm, the pressure of the fluid functions as a force to push up the substrate holding head 17A, resulting in the formation of a clearance between the sealing member 18A and the substrate 13. As indicated by the arrow in FIG. 3, since the fluid under pressure flows out through the clearance between the substrate 13 and the sealing member 18A and through grooves 19a of the guiding member 19A, the pressure in the space 21A is lowered. As a result, the pressure of the fluid in the space 21A automatically coincides with the pressing force applied to the rotary shaft 16A so that the substrate 13 is pressed against the polishing pad 12 with a steady pressing force.

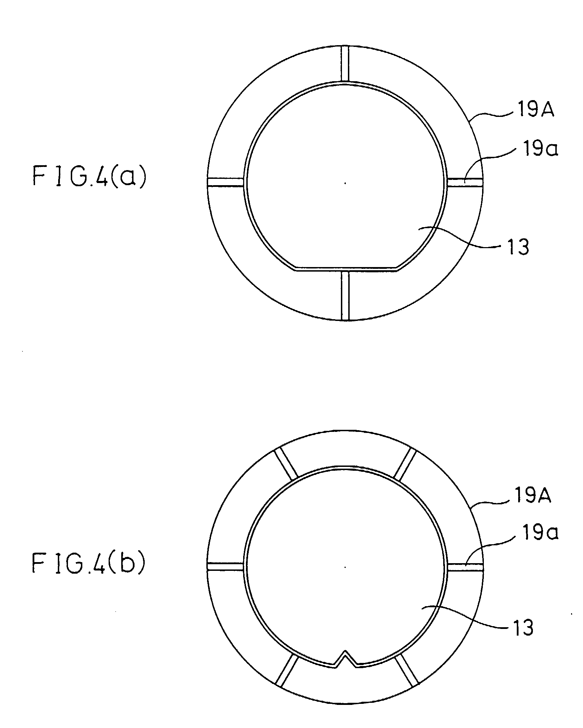

If the sum of the thickness of the substrate 13 and the thickness of the sealing member 18A is determined to be larger than the thickness of the guiding member 19A by about 0.01 to 0.1 mm so that the surface (lower face) of the substrate 13 to be polished protrudes downward from the back face of the guiding member 19A by about 0.01 to 0.1 mm, the fluid under pressure leaking out through the clearance between the substrate 13 and the sealing member 18A will flow out from below the guiding member 19A, since the guiding member 19A is kept from contact with the polishing pad 12. However, if the polishing pad 12 is elastically deformed or the abrasive agent flows into the clearance between the guiding member 19A and the polishing pad 12, there may be cases where the fluid under pressure leaking out cannot flow out smoothly from below the guiding member 19A and confined within the inside of the guiding member 19A. If the fluid under pressure leaking out of the space 21A is confined within the inside of the guiding member 19A, the fluid under pressure flows into the clearance between the substrate 13 and the polishing pad 12 and serves as a force to push up the substrate 13, thus reducing a force to press the substrate 13 against the polishing pad 12. To avoid such a situation, the back face of the guiding member 19A is formed with a plurality of grooves 19a properly spaced which connect the inside of the guiding member 19A to the outside thereof and allow the fluid under pressure leaking out of the space 21A to flow to the outside (see FIGS. 4(a) and 4(b)).

During polishing, the substrate 13 does not rotate in association with the rotating substrate holding head 17A, since the substrate 13 is kept from contact with the sealing member 18A and the guiding member 19A. Although the substrate 13 does not rotate, the rotation of the table 11 achieves relative rotation between the table 11 and the substrate 13, so that the lower face of the substrate 13 is polished. In the case where the substrate 13 should be rotated in association with the substrate holding head 17A, that portion of the inner surface of the guiding member 19A which corresponds to the orientation flat of the substrate 13 is formed linearly as shown in FIG. 4(a) or, alternatively, the substrate 13 is formed with a recessed portion while the guiding member 19A is formed with a projecting portion, which prevents relative rotation between the substrate 13 and the guiding member 19A. Consequently, that portion of the lower face of the substrate 13 which is in contact with the guiding member 19A is prevented from being polished and damaged.

As described above, with the apparatus for holding a substrate to be polished or by the method of polishing a substrate according to the first embodiment, the substrate 13 is pressed against the polishing pad 12 under the pressure of the fluid supplied to the space 21A, so that the substrate 13 can be pressed against the polishing pad 12 with an equal force even when the polishing surface of the polished pad 12 is rugged or the substrate 13 is deformed, resulting in equal polishing with respect to the substrate 13.

Since the lower face of the substrate is not pressed directly by the substrate holding head as in the first conventional embodiment, the substrate 13 can be pressed against the polishing pad 12 with an equal pressing force even when foreign substances such as particles are attached to the upper face of the substrate.

Moreover, since the substrate 13 can be held by the substrate holding head 17A through mere suction of the atmosphere through the fluid flow path 20A, the substrate 13 can be held and conveyed easily.

Hence, with the apparatus for holding a substrate to be polished or by the method of polishing the substrate according to the first embodiment, equal polishing can be performed with respect to the substrate 13 even when the table 11 or polishing pad 12 is rugged or the thickness of the substrate 13 varies from portion to portion, which facilitates the mounting and dismounting of the substrate 13 and the conveyance thereof.

### (Second Embodiment)

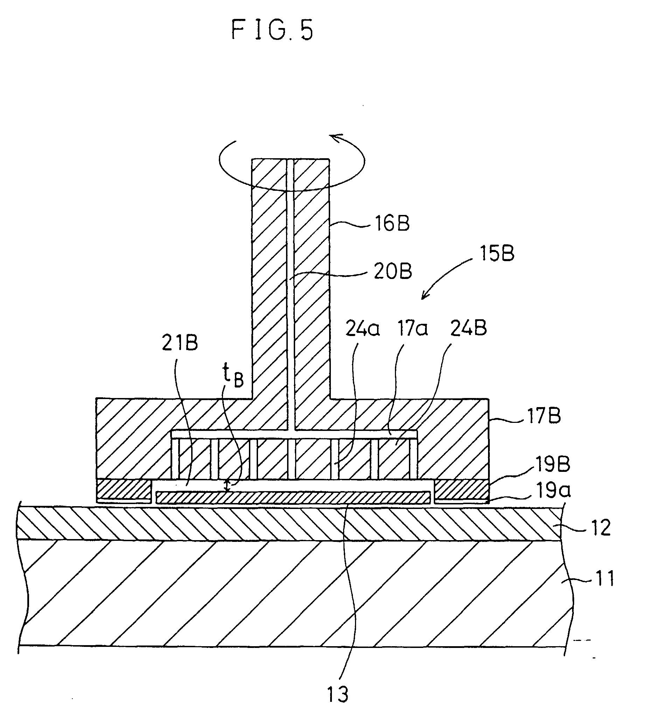

FIG. 5 is a schematic cross-sectional view useful in understanding the present invention and showing an apparatus for holding a substrate to be polished, in which is shown a rotatable table 11 having a flat surface which is made of a rigid material. To the top face of the table 11 is adhered an elastic polishing pad 12.

Above the table 11 is provided a substrate holding apparatus 15B for holding a substrate 13, which includes: a rotary shaft 16B; a substrate holding head 17B in the form of a disc which is provided integrally on the lower edge of the rotary shaft 16B and has a recessed portion 17a in the back face thereof; a guiding member 19B in the form of a ring which is fastened to the peripheral portion of the lower face of the substrate holding head 17B; and a fluid flow path 20B.

This apparatus is different from the first embodiment in that the sealing member 18A provided in the first embodiment is not provided and that a fluid distributing plate 24B with distribution holes 24a are provided integrally with the substrate holding head 17B so as to distribute a fluid under pressure flowing through the fluid flow path 20B and supply the distributed fluid under pressure to a space 21B.

Moreover, although the first embodiment has used a mechanism whereby the pressure of the fluid supplied to the space 21A automatically coincides with the pressing force applied to the rotary shaft 16A, the presently described appartus uses a mechanism whereby the pressure of the fluid passing through the space 21B automatically coincides with the pressing force applied to the rotary shaft 16B, while the fluid under pressure supplied to the space 21B is constantly allowed to flow to the outside, so that the substrate 13 is pressed against a polishing pad 12 under the pressure of the flowing fluid which is coincident with the pressing force applied to the rotary shaft 16B.

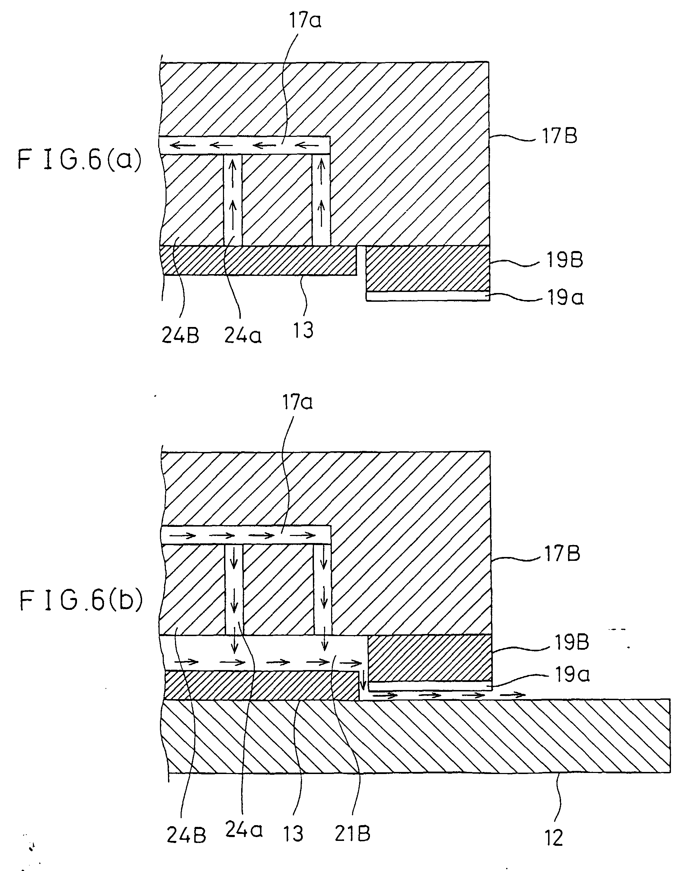

Below, a description will be given to a polishing method implemented by using the above apparatus for polishing a substrate with reference to FIGS. 6(a) and 6(b).

A description will be given first to operation during the conveyance of the substrate 13. The substrate 13 or substrate holding apparatus 15B is moved horizontally so that the substrate 13 is placed under the substrate holding head 17B. The substrate holding head 17B is then moved downward to be closer to the substrate 13. Subsequently, the air is discharged by suction from the recessed portion 17a of the substrate holding head 17B through the fluid flow path 20B to achieve a reduced pressure in the space below the fluid distributing plate 24B, so that the substrate 13 is attracted by the fluid distributing plate 24B and held positively by the substrate holding head 17B, as shown in FIG. 6(a). The substrate holding head 17B holding the substrate 13 is moved horizontally to convey the substrate 13 to a position above the polishing pad 12 over the table 11. In this manner, the substrate 13 can be held and conveyed easily and positively. Next, the structure of this apparatus for holding a substrate to be polished will be described in detail, while operation during polishing is described.

The substrate 13 is placed on the polishing pad 12 by restoring an atmospheric pressure in the fluid flow path 20B and in the recessed portion 17a of the substrate holding head 17B, followed by the application of a downward pressing force to the rotary shaft 16B. In the case of pressing the substrate 13 of silicon having a diameter of 8 inches against the polishing pad 12 under a pressure of 500 g/cm² so that the substrate 13 is polished, the pressing force applied to the rotary shaft 16B becomes 157 kg. In this case, the space 21B defined by the substrate holding head 17B, guiding member 19B, and substrate 13 is supplied with a fluid under a pressure of, e.g., 600 g/cm². Subsequently, the table 11 and the substrate holding head 17B are rotated relative to each other, while an abrasive agent containing abrasive grains is supplied dropwise onto the polishing pad 12. Since the substrate 13 slides over the polishing pad 12 with its lower face kept in contact with the polishing pad 12, the polished face of the substrate 13 becomes less rugged and more smooth. The guiding member 19B prevents the substrate 13 from thrusting out due to a centrifugal force accompanying the rotation, similarly to the first embodiment. With the present apparatus, however, the guiding member 19B defines the space 21B in conjunction with the substrate holding head 17B, fluid distributing plate 24B, and substrate 13, which is different from the first embodiment.

Here, a consideration will be given to the height t_{B} of the space 21B.

The fluid under pressure supplied to the space 21B through the fluid flow path 20B presses the substrate 13 from its upper face against the polishing pad 12, while flowing to the outside through the clearance between the substrate 13 and the guiding member 19B and through grooves 19a. If the height t_{B} of the space 21B is small, a resistance to the flow of the fluid is produced in the space 21B, which causes variations in pressure inside the space 21B, resulting in unequal pressing of the substrate 13. Hence, it is required to set the height t_{B} of the space 21B to a value which barely produces a pressure loss in the fluid under pressure flowing through the space 21B. The height t_{B} of the space 21B is determined by a difference between the thickness of the guiding member 19B and the thickness of the substrate 13. In the case of using a fluid with low viscosity such as water or air (nitrogen) as the fluid under pressure, variations in pressure are rarely observed inside the space 21B if the height t_{B} of the space 21A is set to a value equal to or larger than 1/1000, preferably a value equal to or larger 2/1000, of a dimension of the substrate 13. Specifically, it is preferred to set the height t_{B} of the space 21B to 0.5 mm.

As for the diameter, number, and arrangement of the distribution holes 24a formed in the fluid distributing plate 24B, they are preferably determined such that the fluid supplied through the distribution holes 24a to the space 21B equally presses the substrate 13. The distribution holes 24a are preferably arranged concentrically and radially. The fluid distributing plate 24B may also be composed of a porous plate.

As described above, since the pressure of the fluid supplied to the space 21B through the fluid flow path 20B is larger than the pressing force applied to the rotary shaft 16B, if the distance between the substrate 13 and the guiding member 19B is set to about 0.1 mm, the fluid under pressure flows to the outside through the clearance between the substrate 13 and the guiding member 19B and through the grooves 19a of the guiding member 19B as indicated by the arrow in FIG. 6(b), which lowers the pressure in the space 21B. As a result, the pressure of the fluid under pressure passing through the space 21B automatically coincides with the pressing force applied to the rotary shaft 16B and the substrate 13 is pressed against the polishing pad 12 with a steady pressing force.

Moreover, since the pressure of the fluid supplied to the space 21B through the fluid flow path 20B is larger than the pressing force applied to the rotary shaft 16B, the pressure of the fluid serves as a force to push up the substrate holding head 17, resulting in the formation of a clearance between the substrate holding head 17 and the polishing pad 12 through which the fluid flows to the outside. However, if the polishing pad 12 is elastically deformed or the abrasive agent flows into the clearance between the guiding member 19B and the polishing pad 12, there may be cases where the fluid under pressure cannot flow to the outside smoothly from below the guiding member 19B and confined within the inside of the guiding member 19B. If the fluid under pressure is confined within the inside of the guiding member 19B, the fluid under pressure flows into the clearance between the substrate 13 and the polishing pad 12 and pushes up the substrate 13, thus reducing a force to press the substrate 13 against the polishing pad 12. To avoid such a situation, the back face of the guiding member 19B is formed with a plurality of grooves 19a properly spaced, similarly to the first embodiment.

Thus, with the apparatus for holding a substrate to be polished or by the method of polishing a substrate according to the second embodiment, the pressure of the fluid supplied to the space 21B through the distribution holes 24a of the fluid distributing plate 24B and flowing out through the grooves 19a of the guiding member 19 presses the substrate 13 against the polishing pad 12, so that the substrate 13 can be pressed against the polishing pad 12 with an equal pressing force even when the polishing surface of the polishing pad 12 is rugged or the substrate 13 is deformed, resulting in equal polishing with respect to the substrate 13.

Moreover, the substrate 13 can be pressed against the polishing pad 12 with an equal pressing force even when foreign substances such as particles are attached to the upper face of the substrate.

Furthermore, since the substrate 13 can be attracted by the substrate holding head 17B through mere suction of the substrate 13 through the distribution holes 24a of the fluid distributing plate 24B, the substrate 13 can be held and conveyed easily.

Hence, with the apparatus for holding a substrate to be polished or by the method of polishing a substrate according to Figs. 5 and 6, polishing can be performed with respect to the substrate 13 even when the table 11 or polishing pad 12 is rugged or the thickness of the substrate 13 varies from portion to portion, which facilitates the mounting and dismounting of the substrate 13 and the conveyance thereof. (Second Embodiment)

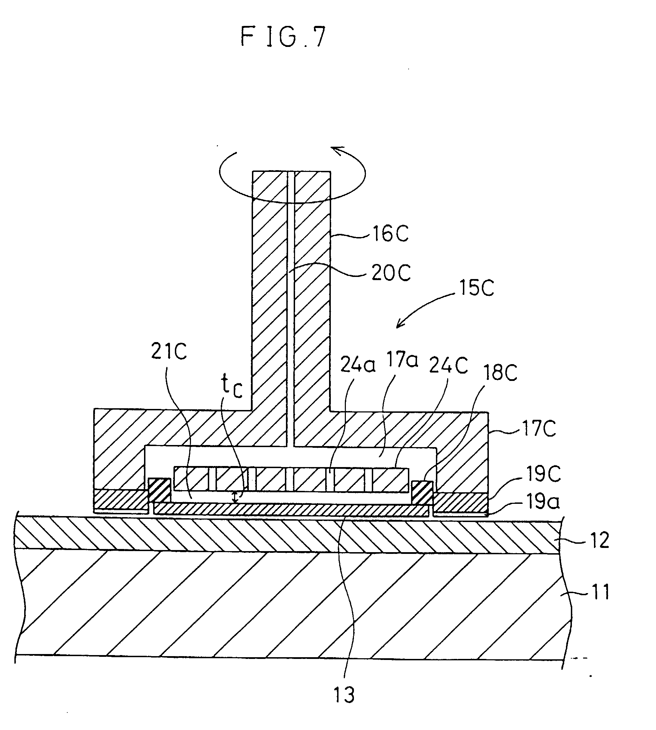

FIG. 7 is a schematic cross-sectional view of an apparatus for holding a substrate to be polished according to a second embodiment of the present invention, in which is shown a rotatable table 11 having a flat surface which is made of a rigid material. To the top face of the table 11 is adhered an elastic polishing pad 12.

Above the table 11 is provided a substrate holding apparatus 15C for holding a substrate 13, which includes: a rotary shaft 16C; a substrate holding head 17C in the form of a disc which is provided integrally on the lower edge of the rotary shaft 16C and has a recessed portion 17a in the back face thereof; a fluid distributing plate 24C with distribution holes 24a which is provided integrally with the substrate holding head 17C in the recessed portion 17a of the substrate holding head 17C; a guiding member 19C in the form of a ring which is fastened to the peripheral portion of the back face of the substrate holding head 17C; a sealing member 18C in the form of a ring which is made of an elastic material and provided vertically movable inside the guiding member 19C; and a fluid flow path 20C.

The second embodiment is different from the apparatus of Fig. 5 in that a sealing member 18c is provided vertically movable inside the guiding member 19C. In this case, the height of the recessed portion 17a of the substrate holding head 17C is set larger than the height of the sealing member 18C.

Moreover, although the first embodiment has used the mechanism whereby the pressure of the fluid supplied to the space 21A or 21B automatically coincides with the pressing force applied to the substrate holding head 17A or 17B so that the pressure of the fluid which is coincident with the pressing force applied to the substrate holding head 17A or 17B presses the substrate 13 against the polishing pad 12, the second embodiment uses a mechanism whereby the pressure of the fluid supplied to the space 21C is made equal to the pressing force applied to the substrate holding head 17C so that the pressure of the fluid supplied to the space 21C presses the substrate 13 against the polishing pad 12.

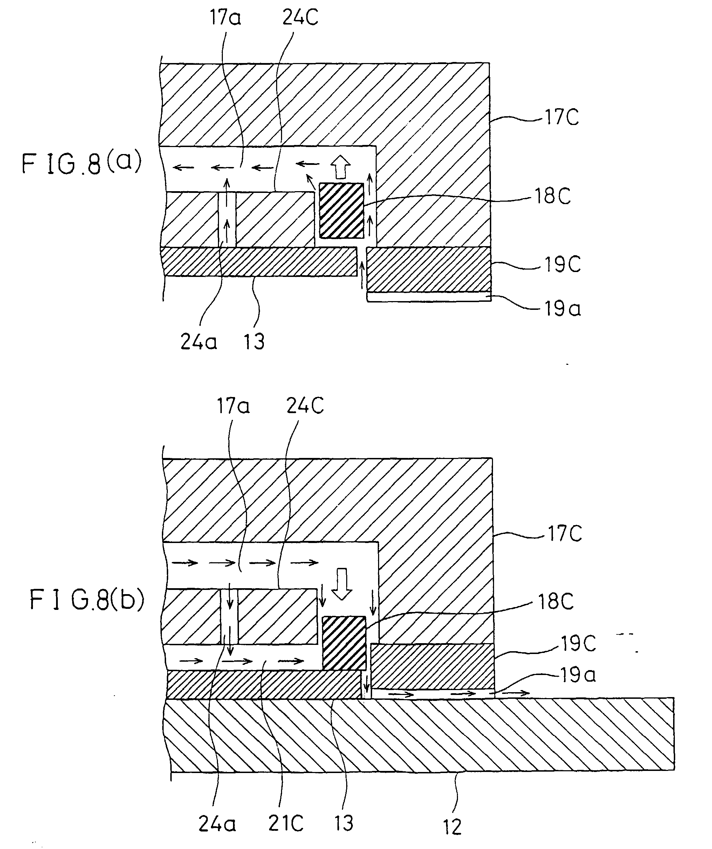

Below, a description will be given to a method of polishing a substrate implemented by the apparatus for holding a substrate to be polished according to the second embodiment with reference to FIGS. 8(a) and 8(b).

A description will be given first to operation during the conveyance of the substrate 13. The substrate 13 or substrate holding apparatus 15C is moved horizontally so that the substrate 13 is placed under the substrate holding head 17C. The substrate holding head 17C is then moved downward to be closer to the substrate 13. Subsequently, the air is discharged by suction from the recessed portion 17a of the substrate holding head 17C through the fluid flow path 20C to achieve a reduced pressure in the space below the fluid distributing plate 24C, so that the substrate 13 is attracted by the fluid distributing plate 24C and held positively by the substrate holding head 17C as shown in FIG. 8(a). In this case, under a reduced pressure in the recessed portion 17a of the substrate holding head 17C, the sealing member 18C moves upward apart from the substrate 13. The substrate holding head 17C holding the substrate 13 is then moved horizontally to convey the substrate 13 to a position above the polishing pad 12, so that the substrate 13 can be held and conveyed easily and positively.

Next, the structure of the apparatus for holding a substrate to be polished according to the second embodiment will be described in detail, while operation during polishing is described.

An atmospheric pressure is restored in the recessed portion 17a of the substrate holding head 17C and in the space 21C by halting the suction through the fluid flow path 20C, followed by the application of a downward pressing force to the rotary shaft 16C. In the case of pressing the substrate 13 of silicon having a diameter of 8 inches against the polishing pad 12 under a pressure of 500 g/cm² so that the substrate 13 is polished, the pressing force applied to the rotary shaft 16C becomes 157 kg, which indicates that a force of 160 kg should be applied to the rotary shaft 16C. In this case, the space 21C is supplied with a fluid under a pressure of 500 g/cm². Subsequently, the table 11 and the substrate holding head 17C are rotated relative to each other, while an abrasive containing abrasive grains is supplied dropwise onto the polishing pad 12. Since the substrate 13 slides over the polishing pad 12 with its lower face kept in contact with the polishing pad 12 as shown in FIG. 8(b), the polished face of the substrate 13 becomes less rugged and more smooth. The sealing member 18C defines the space 21C in conjunction with the fluid distributing plate 24C and substrate 13, while the guiding member 19C functions to prevent the substrate 13 from thrusting out due to a centrifugal force accompanying the rotation.

Here, a consideration will be given to a relationship between the pressing force applied to the rotary shaft 16C and the pressure of the fluid supplied to the space 21C. When the pressing force applied to rotary shaft 16C is larger than a value obtained by multiplying the pressure of the fluid supplied to the space 21C by the area of the substrate 13, the guiding member 19C presses the polishing pad 12 to previously cause elastic deformation of the polishing pad 12, thereby effectively suppressing an increase in polishing rate at the peripheral portion of the substrate 13. Therefore, the pressure of the fluid supplied to the space 21C is preferably less than a value obtained by dividing the pressing force applied to the rotary shaft 16c by the area of the substrate 13 and, more preferably, the pressing force applied to the guiding member 19C is on the same level as the pressure of the fluid.

Next, a consideration will be given to the height t_{C} of the space 21C.

Since the recessed portion 17a of the substrate holding head 17C is connecting to the space 21C via the distribution holes 24a of the fluid distributing plate 24C, the pressure in the recessed portion 17a is equal to the pressure in the space 21C. However, since the sealing member 18C is not fastened to the substrate holding head 17C, the fluid under pressure supplied to the space 21C leaks out through the clearance between the sealing member 18C and the substrate 13 due to the rotation of the substrate 13 during polishing and the rugged upper face of the substrate 13. If the height t_{C} of the space 21C is small, a resistance to the flow of the fluid is produced in the space 21C, which causes variations in pressure in the space 21C, resulting in unequal pressing of the substrate 13. Hence, it is required to set the height t_{C} of the space 21C to a value which barely produces a pressure loss in the fluid under pressure flowing through the space 21C. The height t_{C} of the space 21C is determined by a difference between the thickness of the guiding member 19C and the thickness of the substrate 13. In the case of using a fluid with low viscosity such as water or air (nitrogen) as the fluid under pressure, variations in pressure are rarely observed inside the space 21C if the height t_{C} of the space 21A is set to a value equal to or larger than 1/1000, preferably a value equal to or larger than 2/1000, of a dimension of the substrate 13. Specifically, it is preferred to set the height t_{C} of the space 21C to 0.5 mm.

As for the diameter, number, and arrangement of the distribution holes 24a formed in the fluid distributing plate 24C, they are preferably determined so that the fluid under pressure supplied through the distribution holes 24a to the space 21C equally presses the substrate 13. The distribution holes 24a are preferably arranged concentrically and radially. The fluid distributing plate 24C may also be composed of a porous plate.

As described above, since the back face of the guiding member 19C is flush with the lower face of the substrate 13 and the sealing member 18C is pressed downward by the fluid supplied to the space 21C, the back face of the sealing member 18C is in contact with the upper face of the substrate 13. Consequently, if the weight of the sealing member 18C is ignored when the area of the top face of the sealing member 18C is equal to the area of the back face thereof, the peripheral portion of the substrate 13 is pressed against the polishing pad 12 with an equal pressing force to that applied to the central portion of the substrate 13.

Since the sealing member 18C is pushed up by the fluid supplied to the space 21C, the fluid under pressure is liable to leak out through the interface between the sealing member 18C and the substrate 13, so that the area of the top face of the sealing member 18C is preferably larger than the area of the back face thereof. However, since the peripheral portion of the substrate 13 is actually pressed with a force larger than the force applied to the central portion thereof by the weight of the sealing member 18C, it is sufficient to set the area of the top face of the sealing member 18C slightly larger than the area of the back face thereof.

Since the substrate 13 and the sealing member 18C are merely in contact with each other, the fluid under pressure in the space 21C leaks out through the clearance between the substrate 13 and the sealing member 18C. In this case, since the pressing force applied to the rotary shaft 16C is slightly larger than the pressure of the fluid supplied to the space 21C unlike the first and second embodiments, the fluid leaking out of the space 21C neither pushes up the substrate holding head 17C and guiding member 19C nor flows out through the clearance between the guiding member 19C and the polishing pad 12. When the fluid leaking out is confined by the guiding member 19C, the fluid flows into the clearance between the substrate 13 and the polishing pad 12 and pushes up the substrate 13, which reduces a force to press the substrate 13 against the polishing pad 12. To avoid such a situation, it is preferable to set the distance between the substrate 13 and the sealing member 18C to about 0.1 mm and to form the back face of the guiding member 19C with a plurality of grooves 19a properly spaced, similarly to the first embodiment.

As described above, with the apparatus for polishing a substrate and by the method of polishing a substrate according to the second embodiment, the substrate 13 is pressed against the polishing pad 12 under the pressure of the fluid supplied through the distribution holes 24a of the fluid distributing plate 24C to the space 21C, so that the substrate 13 can be pressed against the polishing pad 12 with an equal pressing force even when the polishing pad 12 is rugged or the substrate 13 is deformed, resulting in equal polishing with respect to the substrate 13.

Moreover, even when such foreign substances as particles are attached to the upper face of the substrate 13, the substrate 13 can be pressed against the polishing pad 12 with an equal pressing force.

Furthermore, since the substrate 13 can be attracted by the substrate holding head 17C through mere suction through the distribution holes 24a of the fluid distributing plate 24C, the substrate 13 can be held and conveyed easily.

Thus, with the apparatus for holding a substrate to be polished or by the method of polishing a substrate according to the second embodiment, equal polishing can be performed with respect to the substrate 13 even when the table 11 or polishing pad 12 is rugged or the thickness of the substrate 13 varies from portion to portion, which facilitates the mounting and dismounting of the substrate 13 and the conveyance thereof.

Below, a description will be given to another apparatus and method for polishing a substrate useful in understanding the present invention.

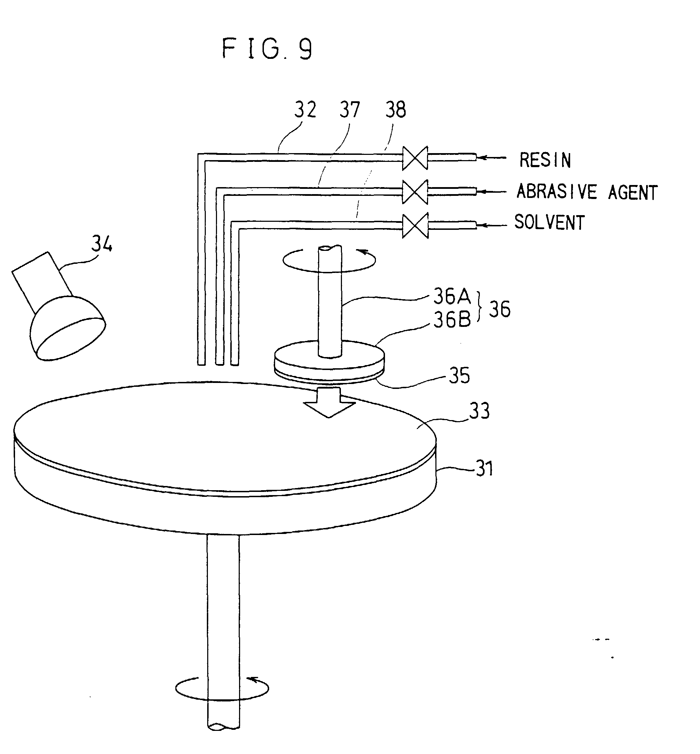

FIG. 9 schematically shows the structure of this apparatus for polishing a substrate, in which is shown a rotatable table having a flat surface which is made of a rigid material. Above the table 31 is provided a first pipe 32 for supplying a thermosetting liquid resin. The liquid resin is supplied from the first pipe 32 to the entire surface of the table 31 so that the resin which has been uniformly spread under surface tension is cured with the application of heat, resulting in the formation of a resin film 33 for polishing over the surface of the table 31. In this case, the resin is supplied dropwise from the first pipe 32 while the table 31 is rotated, so that the resin is spread under surface tension to form the resin film 33 for polishing with a uniform thickness over the table 31. Over the table 31, the first pipe 32 reciprocally moves in the radial direction from the vicinity of the center of the table 31, while dropping the resin in a prescribed amount onto the table 31 to supply the resin equally over the table 31. The first pipe 32 moves outwardly from above the table 31 when it does not supply the resin. In a position diagonally above the table 31 is provided a heating lamp 34 for heating and curing the resin supplied to the surface of the table 31.

The thickness of the resin film 33 for polishing is on the order of 0.01 mm and about 1/10 of the thickness of a conventional polishing pad, which is on the order of 0.1 mm. As the resin for forming the resin film 33 for polishing, polyurethane, polyethylene, polyimide, or the like can be used. The resin for forming the resin film 33 for polishing can be either hard or soft.

As shown in FIG. 9, a substrate holding apparatus 36 for holding a substrate 35 is placed above the table 31. The substrate holding apparatus 36 includes: a rotary shaft 36A rotated by rotary driving means (not shown); and a substrate holding head 36B in the form of a disc which is integrally formed on the lower edge of the rotary shaft 36A to hold the substrate 35.

Above the table 31 is provided a second pipe 37 for supplying an abrasive agent onto the resin film 33 for polishing formed over the table 31 when the substrate 35 is polished. The substrate 35 is polished with the abrasive agent supplied dropwise from the second pipe 37 onto the resin film 33 for polishing. The second pipe 37 moves to a position above the central portion of the table 31 when it supplies the abrasive agent, while it moves outwardly from above the table 31 when it does not supply the abrasive agent.

Above the table 31 is provided a third pipe 38 for supplying a solvent which dissolves the resin film 33 for polishing formed over the surface of the table 31. When the resin film 33 for polishing is worn out, it is dissolved in the solvent supplied from the third pipe 38 and removed. Over the table 31, the third pipe 38 radially moves from the vicinity of the center of the table 31, while dropping the solvent in a prescribed amount onto the table 31 so that the resin film 33 for polishing that has worn out is dissolved and removed. The third pipe 38 moves outwardly from above the table 31 when the resin film 33 for polishing should not be dissolved.

Thus, with this apparatus for polishing a substrate , the liquid resin is supplied dropwise onto the rotating table 31 so that the resin is spread under surface tension and cured. Consequently, the resin film 33 for polishing which is flat and uniform in thickness can be formed over the surface of the table 31.

Each of the table 31 and the substrate holding apparatus 36 is made of a material which is not damaged by the solvent supplied from the third pipe 38, such as alumina. In this case, a protective pad made of, e.g., an acrylic resin may be adhered to the surface of the table 31 for a protecting purpose so that the protective pad damaged by breakage of the substrate 35 or the like is replaced as necessary.

Alternatively, the first and third pipes 32 and 38 may be implemented by a single pipe so that it is switched between the supply of the resin and the supply of the solvent by means of a switching valve or the like.

Although the thermosetting resin is described to be supplied from the first pipe 32 and cured with the application of heat , a photo-curing resin may be supplied instead from the first pipe 32 and cured by the radiation of an ultraviolet ray.

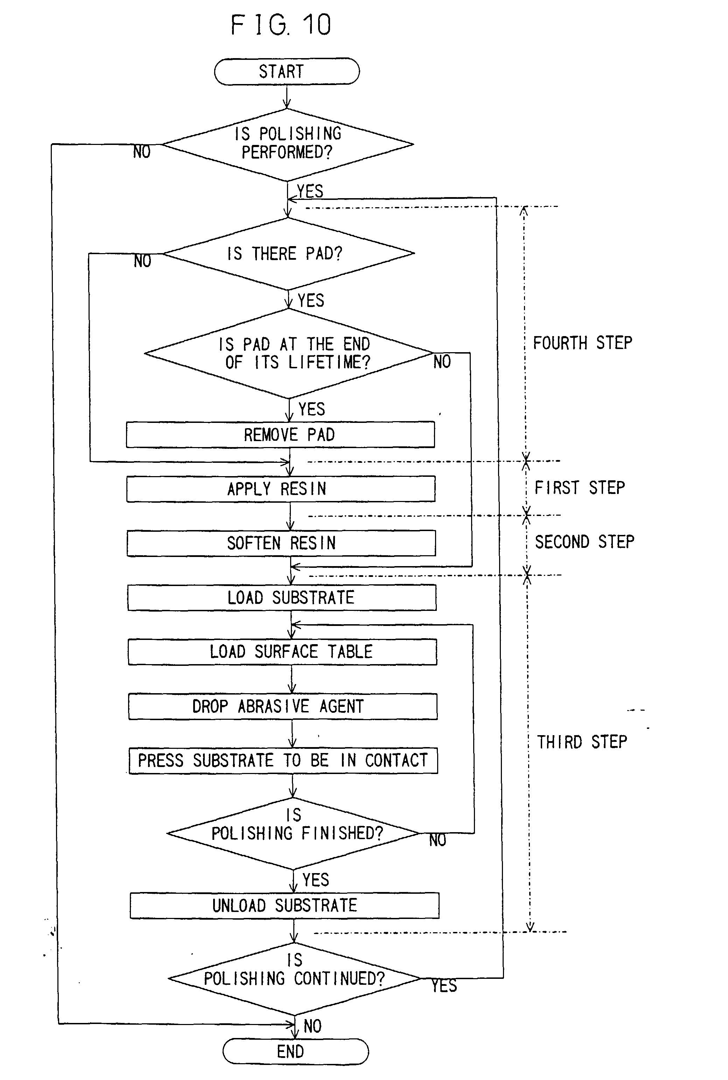

Below, a polishing method using the above apparatus for polishing a substrate will be described based on the flow chart of FIG. 10.

In a first step, a polyurethane resin dissolved in a solvent, for example, is supplied dropwise onto the table 31, while the table 31 is rotated at, e.g., 30 r.p.m., so as to cover the entire surface of the table 31.

In a second step, the rotation of the table 31 is halted so that the resin on the table 31 is flattened under its own surface tension. Subsequently, the resin over the table 31 is cured with the application of heat by the heating lamp 34 while the table 31 is slowly rotated, resulting in the resin film 33 for polishing (which is referred to as "pad" in FIG. 10 for convenience). In this case, the polyurethane resin dissolved in a solvent is heated to 60 °C, while the table 31 is rotated at, e.g., 5 r.p.m., to evaporate the solvent and form the resin film 33 for polishing.

In a third step, the substrate 35 is held by the substrate holding apparatus 36 and moved to a position above the table 31. Thereafter, an abrasive agent containing abrasive grains is supplied dropwise onto the table 31, while the table 31 is rotated, and the substrate holding apparatus 36 is moved downward while rotated in the same direction as the table 31 so that the substrate 35 held by the substrate holding apparatus 36 is pressed against the resin film 33 for polishing and polished. When the polishing of the substrate 35 is complete, the substrate holding apparatus 36 is moved from above the table 31 to a given position to unload the substrate 35. For example, the polishing conditions for polishing the substrate 35 composed of a wafer having a diameter of 200 mm are set so that an abrasive agent composed of an alkaline solution of pH 10 to 11 containing 10 to 15 wt% of silica is dropped at a rate of 200 cc/min, while the table 31 is rotated at 100 r.p.m., and the substrate 35 is pressed against the resin film 33 for polishing to receive a pressure of 300 g/cm² on its surface, while the substrate holding apparatus 36 is rotated at 20 r.p.m.

In a fourth step, the solvent for dissolving the resin film 33 for polishing, e.g., an organic solvent such as acetone or a concentrated sulfuric acid is dropped onto the resin film 33 for polishing over the table 3, while the table 31 is rotated, thereby dissolving and removing the resin film 33 for polishing from the surface of the table 31.

By repeatedly performing the above first to fourth steps, the resin film 33 for polishing having varied thickness and an increased degree of ruggedness as a result of polishing, i.e., the resin film 33 for polishing that has worn out can be renewed without a dressing process. Specifically, after the resin film 33 for polishing that has worn out is removed, a new resin film 33 for polishing having a uniform thickness and a flat surface free from ruggedness is formed to stably polish the substrate 35.

Although the liquid resin is described to be supplied dropwise while the table 31 is rotated, it is preferable to control the rotation speed of the table 31 and the amount of the resin to be dropped based on the viscosity of the resin and the type and amount of the solvent.

Although the thermosetting resin is described to be cured with the application of heat by the heating lamp 34 to form the resin film 33 for polishing in the fourth embodiment, the resin may alternatively be cured by the application of heat generated in the course of raising the temperature of the table 31.

Although the abrasive agent containing abrasive grains is described to be supplied, the resin containing abrasive grains may be cured instead to form the resin film 33 for polishing so that a liquid containing no abrasive grains and having controlled pH is supplied onto the resin film 33 for polishing.

In the above process of Fig.10, the resin film 33 for polishing may be renewed after polishing a given number of substrates 35. Alternatively, the resin film 33 for polishing may be renewed at the end of its lifetime, i.e., at a time at which surface uniformity or the ability to tolerate variations in the level of the resin film 33 for polishing exceeds the permissible level.

Alternatively, the original surface uniformity and ability to tolerate variations in the level of the resin film 33 for polishing may be restored without removing the resin film 33 for polishing by supplying the resin from the second pipe 32 onto the resin film 33 for polishing that has worn out at the end of its lifetime to flatten the resin film 33 for polishing. In this case, since the resin film 33 is extremely thin compared with a conventional polishing pad, the surface of the resin film 33 for polishing can be flattened by supplying the resin.

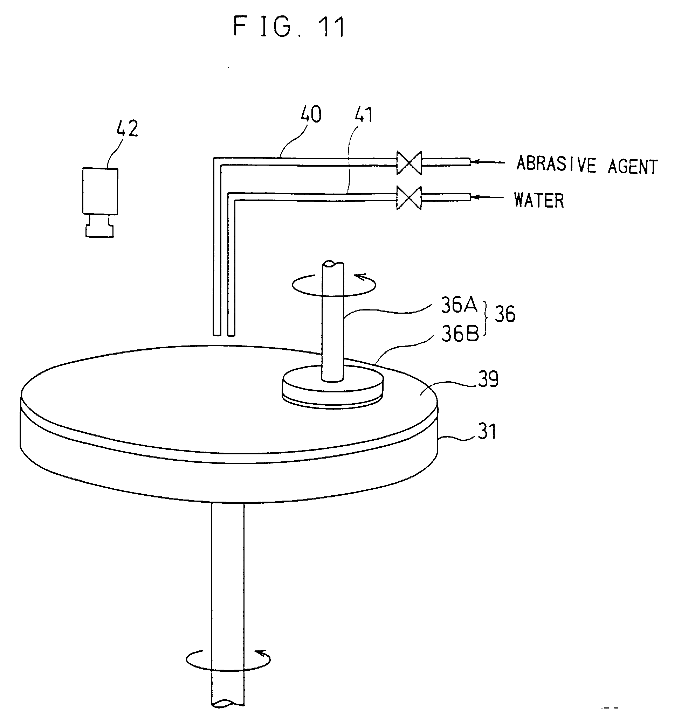

FIG. 11 schematically shows the structure of another apparatus for polishing a substrate useful in understanding the present invention, in which are shown: a rotatable table 31 having a flat surface which is made of a rigid material and is, e.g., red in color; a white, translucent polishing pad 39 adhered to the table 31; a first pipe 40 for supplying an abrasive agent onto the polishing pad 39; a second pipe 41 for supplying cleaning water onto the polishing pad 39; and a camera 42 for measuring the color intensities of R, G, and B of the polishing pad 39. Above the table 31 are provided: a rotary shaft 36A rotated by rotary driving means (not shown); and a substrate holding apparatus 36 having a substrate holding head 36B in the form of a disc which is provided integrally on the lower edge of the rotary shaft 36 to hold the substrate 35, similarly to the first embodiment.

In the above apparatus for polishing a substrate , after water is supplied from the second pipe 41 to clean the surface of the polishing pad 39 and remove the abrasive, the red color intensity of the table 31 passing through the polishing pad 39 is measured by means of a camera 42. If the thickness of the polishing pad 39 is sufficiently thick, the red color of the table 31 does not pass through the polishing pad 39, so that the camera 42 detects the white color of the polishing pad 39 and therefore the signal intensities of R, G, and B are substantially equal. Since the polishing pad 39 is translucent, the red color of the table 31 passing through the polishing pad 39 increases and the signal intensity of R increases as the polishing pad 39 becomes thinner.

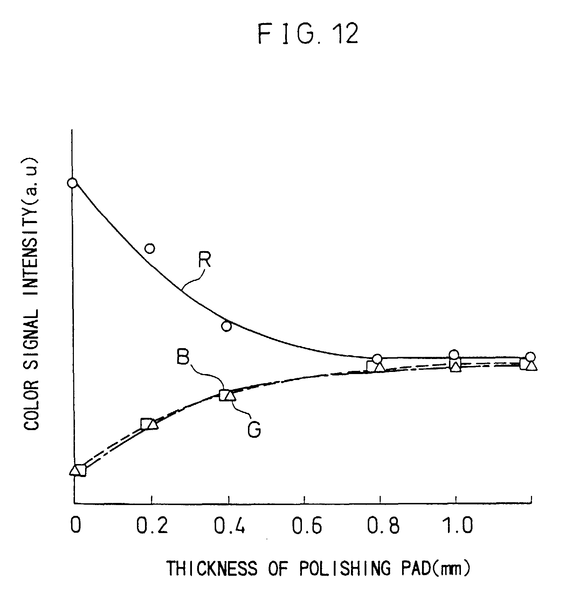

FIG. 12 shows relationships between the thickness of the polishing pad 39 and the signal intensities of R, G, and B, in which the horizontal axis represents the thickness of the polishing pad 39 and the vertical axis represents the signal intensity of color normalized to 1 which is obtained when no polishing pad 39 is provided. As shown in FIG. 12, as the polishing pad 39 becomes thinner, the signal intensity of R becomes higher, while the signal intensities of G and B become lower, which enables the thickness of the polishing pad 39 to be estimated. Moreover, the degree of ruggedness, i.e., variations in the thickness of the polishing pad 39 can be estimated by measuring the signal intensities of R, G, and B at any point of the surface of the table 31.

In the process of fabricating the translucent polishing pad 39, it may be made of a transparent resin containing several wt% of fine particles which do not permeate light or it may be made of a transparent resin formed with fine bubbles to irregularly reflect light.

Although the combination of the red table 31 and the white, translucent polishing pad 39 are described to be used, a combination of a white table 31 and a red, translucent polishing pad 39 may be used instead. In this case, the thickness of the polishing pad 39 can be estimated based on a reduction in the signal intensity of R and increases in the signal intensities of G and B. Various other combinations of colors may also be used instead.

In the case of using a multilayer polishing pad 39, a surface layer of the pad may be translucent, while layers other than the surface layer may be colored, instead of coloring the table 31.

Although the surface of the polishing pad 39 is described to be cleaned with water before the signal intensities of colors are measured with the embodiment of Fig. 5, the abrasive agent on the polishing pad may partially be removed with high-pressure air or the like so that the signal intensities of colors are measured in the area from which the abrasive agent has been removed.

Alternatively, in the above apparatus for polishing a substrate according to Fig. 9, a white, translucent resin film 33 for polishing may be formed by supplying a white, translucent resin from the first pipe 32 onto the table 31 colored in, e.g., red so that the signal intensity of the red color of the table 31 passing through the resin film 33 for polishing is measured. In this case, for example, if the signal intensity of the red color exceeds a specified value, a solvent is supplied from the third pipe 38 onto the table 31 to remove the resin film 33 for polishing and then the resin is supplied from the first pipe 32 to form a new resin film 33 for polishing or the resin is supplied from the first pipe 32 to flatten the surface of the resin film 33 for polishing without the removal of the resin film 33 for polishing.

## Claims

1. Apparatus for holding a substrate (13) to be polished and pressing the held substrate against a polishing pad (12), said apparatus comprising:
a substrate holding head (17A) which can move toward and away from said polishing pad (12), said substrate holding head (17A) having substrate attracting means for attracting the substrate by suction and a fluid supply path (20A) which allows a pressure fluid to be supplied from one end of said fluid supply path (20A) and to flow out from the other end of said fluid supply path (20A), and
a guiding member (19A) in the form of a ring which is provided on said substrate holding head (17A) to hold the substrate (13) to be polished which is disposed on the polishing pad (12) in a given position,
wherein the substrate (13) to be polished which is disposed on the polishing pad (12) is pressed against said polishing pad (12) under a pressure of the pressurized fluid,
**characterized by**
an annular sealing member (18A) fastened to a portion of the substrate holding head (17A) which surrounds the other end of the fluid supply path, the annular sealing member (18A) defining a space (21A) in conjunction with the substrate holding head (17A) and the substrate (13) to be polished which is disposed on the polishing pad (12),
the annular sealing member (18A) and the substrate holding head (17A) being constructed such that the pressurized fluid pushes up the sealing member (18A) and the substrate holding head (17A) and flows to the outside of said space (21A) through the clearance thus generated between the annular sealing member (18A) and the substrate (13) if the pressure of the pressurized fluid exceeds a pressing force applied to the substrate holding head (17A).

2. Apparatus for holding a substrate to be polished and pressing the held substrate (13) against a polishing pad (12), said apparatus comprising:
a substrate holding head (17C) which can move toward and away from said polishing pad (12), the substrate holding head (17C) having substrate attracting means for attracting the substrate by suction and a fluid supply path (20C) which allows a pressurized fluid to be supplied from one end of said fluid supply path and to flow out from the other end of said fluid supply path (20C), and
a guiding member (19C) in the form of a ring being provided on said substrate holding head (17C) to hold the substrate (13) to be polished which is disposed on the polishing pad (12) in a given position,
wherein the substrate (13) to be polished which is disposed on said polishing pad (12) is pressed against the polishing pad (12) under pressure of the pressurized fluid,
**characterized by**
an annular sealing member (18C) which can be brought into contact with and removed from contact with a portion of the substrate holding head (17C) which surrounds the other end of the fluid supply path (20C), the annular sealing member (18C) defining a space (21C) in conjunction with the substrate holding head (17C) and the substrate (13) to be polished which is disposed on the polishing pad (12),
said annular sealing member (18C) being provided vertically movable inside said guiding member (19C),
the annular sealing member (18C) being disposed such that it moves toward the substrate (13) to be polished under pressure of the pressurized fluid supplied from the other end of the fluid supply path to be spaced (21), so that the peripheral portion of the substrate (13) is further pressed against the polishing pad (12).

3. Apparatus for holding a substrate to be polished according to claim 1 or 2,
**characterized by**
said guiding member (19A, 19C) having a connecting path (19a) between an inside and an outside of the guiding member (19A, 19C).

4. Apparatus for holding a substrate to be polished according to on of claims 1 to 3,
**characterized in that**
a portion of said substrate holding head (17A,17C) in which the other end of the fluid supply path (20A,20C) is opened is formed as a flat surface, and the apparatus further comprises:
means for setting a distance (tₐ,t_{c}) between the flat surface and the substrate (13) to be polished which is disposed on the polishing pad (12) to a value equal to or larger than 1/1000 of a diameter of the substrate (13) to be polished.

5. Apparatus for holding a substrate to be polished according to one of the preceding claims,
**characterized in that**
the annular sealing member (18A,18C) is composed of an elastic material.

6. Method of polishing a substrate to be polished by pressing the substrate (13) against a polishing pad (12), the method comprising the steps of:
a first step of lifting and holding the substrate to be polished by suction by means of a substrate holding head so as to convey the held substrate to a position above said polishing pad ;
a second step of releasing the substrate conveyed to the position above said polishing pad from said substrate holding head so as to dispose the substrate on said polishing pad;
a third step of supplying a pressurized fluid to a space (21A) defined by:
- a substrate holding head (17A) which can move toward and away from the polishing pad (12), and which has a guiding member (19A) in the form of a ring which is provided on said substrate holding head (17A) to hold the substrate (13) to be polished which is disposed on the polishing pad (12) in a given position and a fluid supply path (20A) that allows a pressurized fluid to be supplied from one end of the fluid supply path and to flow out from the other end of the fluid supply path (20A);
- an annular sealing member (18A) fastened to a portion of the substrate holding head (17A) which surrounds the other end of the fluid supply path (20A) ; and
- the substrate (13) to be polished;
a fourth step of applying a predetermined pressing force to the substrate holding head (17A) to press the substrate holding head against the polishing pad (12);
a fifth step of pressing the substrate (13) to be polished against the polishing pad (12) under pressure of the pressured fluid supplied from the other end of the fluid supply path (20A) to the space (21A);
such that the pressurized fluid pushes up the annular sealing member (18A) and the substrate holding head (17A) and flows to the outside of said space (21A) through the clearance thus generated between the annular sealing member (18A) and the substrate (13), if the pressure of the pressurized fluid exceeds the pressing force applied to the substrate holding head (17A).

7. Method of polishing a substrate to be polished according to claim 6,
**characterized in that**
a pressure per unit area of the pressurized fluid supplied to the space (21A) is larger than a pressure obtained by dividing the given pressing force by an area of a surface of the substrate (13) to be polished.

8. Method of polishing a substrate to be polished according to claim 7,
**characterized in that**
the pressure per unit area of the pressurized fluid supplied to the space is any value in a range of 1.1 to 2.0 time the pressure obtained by dividing the given pressing force by the area of the surface of the substrate (13) to be polished.

9. Method of polishing a substrate to be polished by pressing the substrate (13) against a polishing pad (12), the method comprising the steps of:
a first step of lifting and holding the substrate to be polished by suction by means of a substrate holding head so as to convey the held substrate to a position above said polishing pad;
a second step of releasing the substrate conveyed to the position above said polishing pad from said substrate holding head so as to dispose the substrate on said polishing pad ;
a third step of supplying a pressurized fluid to a space (21C) defined by:
- a substrate holding head (17C) which can move toward and away from the polishing pad (12) and which has a guiding member (19C) in the form of a ring which is provided on said substrate holding head (17C) to hold the substrate (13) to be polished which is disposed on the polishing pad (12) in a given position and a fluid supply path (20C) that allows a pressurized fluid to be supplied from one end of the fluid supply path (20C) and to flow out from the other end of the fluid supply path (29C);
- an annular sealing member (18C) which surrounds the other end of the fluid supply path (20C) and is provided vertically movable inside said guiding member (19C); and
- the substrate (13) to be polished,
a fourth step of applying a predetermined pressing force to the substrate holding head (17C) to press the substrate holding head against the polishing pad (12); and
a fifth step of pressing the substrate (13) to be polished against the polishing pad (12) under pressure of the pressured fluid supplied from the other end of the fluid supply path (20C) to the space (21 C); and moving the sealing member (18C) toward the substrate (13) to be polished so that the peripheral portion of the substrate (13) to be polished is further pressed against the polishing pad (12).

10. Method of polishing a substrate to be polished according to claim 6 or 9,
**characterized in that**
a portion of the substrate holding head (17A,17C) which holds the substrate (13) is formed as a flat surface, and
the third step includes the step of maintaining a distance (tₐ,t_{c}) between the flat surface and the substrate (13) to be polished disposed on the polishing pad (12) at a value equal to or larger than 1/1000 of a diameter of the substrate (13) to be polished.

## Patentansprüche

1. Vorrichtung zum Halten eines zu polierenden Substrats (13) und zum Pressen des gehaltenen Substrats an eine Polierscheibe (12), wobei die Vorrichtung umfasst:
einen Substrathaltekopf (17A), der sich auf die Polierscheibe (12) zu und von ihr weg bewegen kann, wobei der Substrathaltekopf (17A) eine Substratanzieheinrichtung zum Anziehen des Substrats durch Sog sowie einen Fluidzuführweg (20A) aufweist, der die Zufuhr eines Druckfluids über Ende des Fluidzuführweges (20A) und das Ausströmen über das andere Ende des Fluidzuführweges (20A) ermöglicht, und
ein Führungselement (19A) in Form eines Rings, das an dem Substrathaltekopf (17A) vorhanden ist, um das zu polierende Substrat (13), das sich auf der Polierscheibe (12) befindet, an einer bestimmten Position zu halten,
wobei das zu polierende Substrat (13), das auf der Polierscheibe (12) angeordnet ist, unter einem Druck des unter Druck stehenden Fluids an die Polierscheibe (12) gepresst wird,
**gekennzeichnet durch:**
ein ringförmiges Dichtungselement (18A), das an einem Abschnitt des Substrathaltekopfes (17A) befestigt ist, der das andere Ende des Fluidzuführweges umgibt, wobei das ringförmige Dichtungselement (18A) zusammen mit dem Substrathaltekopf (17A) und dem zu polierenden Substrat (13), das sich auf der Polierscheibe (12) befindet, einen Raum (21A) bildet,
wobei das ringförmige Dichtungselement (18A) und der Substrathaltekopf (17A) so aufgebaut sind, dass das unter Druck stehende Fluid das Dichtungselement (18A) und den Substrathaltekopf (17A) nach oben drückt und über den so hergestellten Zwischenraum zwischen dem ringförmigen Dichtungselement (18A) und dem Substrat (13) aus dem Raum (21A) nach außen strömt, wenn der Druck des unter Druck stehenden Fluids eine Presskraft übersteigt, die auf den Substrathaltekopf (17A) wirkt.

2. Vorrichtung zum Halten eines zu polierenden Substrats und zum Pressen des gehaltenen Substrats (13) an eine Polierscheibe (12), wobei die Vorrichtung umfasst :
einen Substrathaltekopf (17C), der sich auf die Polierscheibe (12) zu und von ihr weg bewegen kann, wobei der Substrathaltekopf (17C) eine Substratanzieheinrichtung zum Anziehen des Substrats durch Sog sowie einen Fluidzuführweg (20C) aufweist, der die Zufuhr eines unter Druck stehenden Fluids über ein Ende des Fluidzuführweges (20C) und das Ausströmen über das andere Ende des Fluidzüführweges (20C) ermöglicht, und
ein Führungselement (19C) in Form eines Rings, der an dem Substrathaltekopf (17C) vorhanden ist, um das zu polierende Substrat (13), das auf der Polierscheibe (12) angeordnet ist, an einer bestimmten Position zu halten,
wobei das zu polierende Substrat (13), das auf der Polierscheibe (12) angeordnet ist, unter einem Druck des unter Druck stehenden Fluids an die Polierscheibe (12) gepresst wird,
**gekennzeichnet durch:**
ein ringförmiges Dichtungselement (18C), das mit einem Abschnitt des Substrathaltekopfes (17C), der das andere Ende des Fluidzuführweges (20C) umgibt, in Kontakt gebracht werden und aus dem Kontakt gelöst werden kann, wobei das ringförmige Dichtungselement (18C) zusammen mit dem Substrathaltekopf (17C) und dem zu polierenden Substrat (13), das sich auf der Polierscheibe (12) befindet, ein Raum (21C) bildet,
wobei das ringförmige Dichtungselement (18C) vertikal beweglich im Inneren des Führungselementes (19C) vorhanden ist,
wobei das ringförmige Dichtungselement (18C) so angeordnet ist, dass es sich unter dem Druck des unter Druck stehenden Fluids, das über das andere Ende des Fluidzuführweges dem Raum (21C) zugeführt wird, auf das zu polierende Substrat (13) zu bewegt, so dass der Randabschnitt des Substrats (13) weiter an die Polierscheibe (12) gepresst wird.

3. Vorrichtung zum Halten eines zu polierenden Substrats nach Anspruch 1 oder 2
**gekennzeichnet durch:**
ein Führungselement (19A, 19C) mit einem Verbindungsweg (19a) zwischen einer Innenseite und einer Außenseite des Führungselementes (19A, 19C).

4. Vorrichtung zum Halten eines zu polierenden Substrats nach einem der Ansprüche 1 bis 3, **dadurch gekennzeichnet,** dass:
ein Abschnitt des Substrathaltekopfes (17A, 17C), in dem sich das andere Ende des Fluidzuführweges (20A, 20C) öffnet, als eine plane Fläche ausgebildet ist, und die Vorrichtung des Weiteren umfasst:
eine Einrichtung zum Einstellen eines Abstandes (tₐ, t_{c}) zwischen der planen Fläche und dem zu polierenden Substrat (13), das sich auf der Polierscheibe (12) befindet ist, auf einen Wert, der 1/1000 eines Durchmessers des zu polierenden Substrates (13) oder mehr beträgt.

5. Vorrichtung zum Halten eines zu polierenden Substrats nach einem der vorangehenden Ansprüche, **dadurch gekennzeichnet,** dass:
das ringförmige Dichtungselement (18A, 18C) aus einem elastischen Material besteht.

6. Verfahren zum Polieren eines zu polierenden Substrats durch Pressen des Substrats (13) an eine Polierscheibe (12), wobei das Verfahren die folgenden Schritte umfasst:
einen ersten Schritt des Anhebens und Haltens des zu polierenden Substrates durch Sog mittels eines Substrathaltekopfes, um das gehaltene Substrat an eine Position über der Polierscheibe zu transportieren;
einen zweiten Schritt des Lösens des an die Position über der Polierscheibe transportierten Substrats von dem Substrathaltekopf, um das Substrat auf der Polierscheibe anzuordnen;
einen dritten Schritt des Zuführens eines unter Druck stehenden Fluids in einen Raum (21A), der gebildet wird durch:
einen Substrathaltekopf (17A), der sich auf die Polierscheibe (12) zu und von ihr weg bewegen kann, und der ein Führungselement (19A) in Form eines Rings, der an dem Substrathaltekopf (17A) vorhanden ist, um das zu polierende Substrat (13), das auf der Polierscheibe (12) angeordnet ist, an einer bestimmten Position zu halten, sowie einen Fluidzuführweg (20A) aufweist, der die Zufuhr eines unter Druck stehenden Fluids über ein Ende des Fluidzuführweges und das Ausströmen über das andere Ende des Fluidzuführweges (20A) ermöglicht;
ein ringförmiges Dichtungselement (18A), das an einem Abschnitt des Substrathaltekopfes (17A) befestigt ist, der das andere Ende des Fluidzuführweges (20A) umgibt; und
das zu polierende Substrat (13);
einen vierten Schritt des Ausübens einer vorgegebenen Presskraft auf den Substrathaltekopf (17A), um den Substrathaltekopf an die Polierscheibe (12) zu pressen;
einen fünften Schritt des Pressens des zu polierenden Substrats (13) an die Polierscheibe (12) unter dem Druck des unter Druck stehenden Fluids, das über das andere Ende des Fluidzuführweges (20A) dem Raum (21A) zugeführt wird;
so dass das unter Druck stehende Fluid das ringförmige Dichtungselement (18A) und den Substrathaltekopf (17A) nach oben drückt und über den so zwischen dem ringförmigen Dichtungselement (18A) und dem Substrat (13) hergestellten Zwischenraum aus dem Raum (21A) nach außen strömt, wenn der Druck des unter Druck stehenden Fluids die Presskraft übersteigt, die auf den Substrathaltekopf (17A) wirkt

7. Verfahren zum Polieren eines zu polierenden Substrats nach Anspruch 6, **dadurch gekennzeichnet**, dass:
ein Druck des dem Raum (21A) zugeführten, unter Druck stehenden Fluids pro Flächeneinheit größer ist als ein Druck, der sich ergibt, wenn die vorgegebene Presskraft durch eine Fläche des zu polierenden Substrats (13) dividiert wird.

8. Verfahren zum Polieren eines zu polierenden Substrats nach Anspruch 7, **dadurch gekennzeichnet,** dass:
der Druck des dem Raum zugeführten, unter Druck stehenden Fluids pro Flächeneinheit ein beliebiger Wert in einem Bereich von 1,1- bis zum 2,0-fachen des Drucks ist, der sich ergibt, wenn die vorgegebene Presskraft durch die Fläche des zu polierenden Substrats (13) dividiert wird.

9. Verfahren zum Polieren eines zu polierenden Substrats durch Pressen des Substrats (13) an eine Polierscheibe (12), wobei das Verfahren die folgenden Schritte umfasst
einen ersten Schritt des Anhebens und Haltens des zu polierenden Substrates durch Sog mittels eines Substrathaltekopfes, um das gehaltene Substrat an eine Position über der Polierscheibe zu transportieren;
einen zweiten Schritt des Lösens des an die Position über der Polierscheibe transportierten Substrats von dem Substrathaltekopf, um das Substrat auf der Polierscheibe anzuordnen;
einen dritten Schritt des Zuführens eines unter Druck stehenden Fluids in einen Raum (21C), der gebildet wird durch:
einen Substrathaltekopf (17C), der sich auf die Polierscheibe (12) zu und von ihr weg bewegen kann, und der ein Führungselement (19C) in Form eines Rings, der an dem Substrathaltekopf (17C) vorhanden ist, um das zu polierende Substrat (13), das an der Polierscheibe (12) angeordnet ist, an einer bestimmten Position zu halten, sowie einen Fluidzuführweg (20C) aufweist, der die Zufuhr eines unter Druck stehenden Fluids über ein Ende des Fluidzuführweges (20C) und das Ausströmen über das andere Ende des Fluidzuführweges (29C) ermöglicht;
ein ringförmiges Dichtungselement (18C), das das andere Ende des Fluidzuführweges (20C) umgibt und vertikal beweglich im Innem des Führungselementes (19C) angeordnet ist; und
das zu polierende Substrat (13);
einen vierten Schritt des Ausübens einer vorgegebenen Presskraft auf den Substrathaltekopf (17), um den Substrathaltekopf an die Polierscheibe (12) zu pressen; und
einen fünften Schritt des Pressens des zu polierenden Substrates (13) an die Polierscheibe (12) unter dem Druck des unter Druck stehenden Fluids, das über das andere Ende des Fluidzuführweges (20C) dem Raum (21C) zugeführt wird; und Bewegen des Dichtungselementes (18C) auf das zu polierende Substrat (13) zu, so dass der Randabschnitt des zu polierenden Substrats (13) weiter an die Polierscheibe (12) gepresst wird.

10. Verfahren zum Polieren eines zu polierenden Substrats nach Anspruch 6 oder 9, **dadurch gekennzeichnet,** dass:
ein Abschnitt des Substrathaltekopfes (17A, 17C), der das Substrat (13) hält, als plane Fläche ausgebildet ist, und
der dritte Schritt den Schritt des Aufrechterhaltens eines Abstandes (tₐ, t_{c}) zwischen der planen Fläche und dem zu polierenden Substrat (13), das sich auf der Polierscheibe (12) befindet ist, auf einen Wert, der 1/1000 eines Durchmessers des zu polierenden Substrats (13) oder mehr beträgt.

## Revendications

1. Dispositif destiné au maintien d'un substrat (13) devant être poli et à appuyer le substrat maintenu contre un patin de polissage (12), ledit dispositif comprenant :
une tête de maintien de substrat (17A) qui peut se déplacer en direction dudit patin de polissage (12) et à l'écart de celui-ci, ladite tête de maintien de substrat (17A) comportant un moyen d'attraction du substrat destiné à attirer le substrat par aspiration et un passage de fourniture de fluide (20A) qui permet à un fluide de pression d'être fourni depuis une première extrémité dudit passage de fourniture de fluide (20A) et de s'écouler à l'extérieur depuis l'autre extrémité dudit passage de fourniture de fluide (20A), et
un élément de guidage (19A) sous la forme d'un anneau qui est disposé sur ladite tête de maintien de substrat (17A) afin de maintenir le substrat (13) devant être poli qui est disposé sur le patin de polissage (12) dans une position donnée,
dans lequel le substrat (13) devant être poli qui est disposé sur le patin de polissage (12) est appuyé contre ledit patin de polissage (12) sous la pression du fluide sous pression,
**caractérisé par**
un élément d'étanchéité annulaire (18A) fixé à une partie de la tête de maintien de substrat (17A) qui entoure l'autre extrémité du passage de fourniture de fluide, l'élément d'étanchéité annulaire (18A) définissant un espace (21A) conjointement avec la tête de maintien de substrat (17A) et le substrat (13) devant être poli qui est disposé sur le patin de polissage (12),
l'élément d'étanchéité annulaire (18A) et la tête de maintien de substrat (17A) étant conçus de sorte que le fluide sous pression repousse vers le haut l'élément d'étanchéité (18A) et la tête de maintien de substrat (17A) et s'écoule vers l'extérieur dudit espace (21A) par l'espace ainsi généré entre l'élément d'étanchéité annulaire (18A) et le substrat (13) si la pression du fluide sous pression dépasse une force de pression appliquée sur la tête de maintien de substrat (17A).

2. Dispositif destiné à maintenir un substrat devant être poli et à appuyer le substrat maintenu (13) contre un patin de polissage (12), ledit dispositif comprenant :
une tête de maintien de substrat (17C) qui peut se déplacer en direction dudit patin de polissage (12) et à l'écart de celui-ci, la tête de maintien de substrat (17C) comportant un moyen d'attraction du substrat destiné à attirer le substrat par aspiration et un passage de fourniture de fluide (20C) qui permet à un fluide sous pression d'être fourni depuis une première extrémité dudit passage de fourniture de fluide et de s'écouler vers l'extérieur depuis l'autre extrémité dudit passage de fourniture de fluide (20C), et
un élément de guidage (19C) sous la forme d'un anneau étant disposé sur ladite tête de maintien de substrat (17C) afin de maintenir le substrat (13) devant être poli qui est disposé sur le patin de polissage (12) dans une position donnée,
dans lequel le substrat (13) devant être poli qui est disposé sur ledit patin de polissage (12) est appuyé contre le patin de polissage (12) sous la pression du fluide sous pression,
**caractérisé par**
un élément d'étanchéité annulaire (18C) qui peut être amené jusqu'en contact avec une partie de la tête de maintien de substrat (17C) qui entoure l'autre extrémité du passage de fourniture de fluide (20C) et être enlevé d'un contact avec celle-ci, l'élément d'étanchéité annulaire (18C) définissant un espace (21C) conjointement avec la tête de maintien de substrat (17C) et le substrat (13) devant être poli qui est disposé sur le patin de polissage (12),
ledit élément d'étanchéité annulaire (18C) étant prévu mobile verticalement à l'intérieur dudit élément de guidage (19C),
l'élément d'étanchéité annulaire (18C) étant disposé de telle sorte qu'il se déplace en direction du substrat (13) devant être poli sous la pression du fluide sous pression fourni depuis l'autre extrémité du passage de fourniture de fluide vers l'espace (21C), de sorte que la partie périphérique du substrat (13) est davantage appuyée contre le patin de polissage (12).

3. Dispositif destiné à maintenir un substrat devant être poli selon la revendication 1 ou 2,
**caractérisé par**
ledit élément de guidage (19A, 19C) comportant un passage de liaison (19a) entre un intérieur et un extérieur de l'élément de guidage (19A, 19C).

4. Dispositif destiné à maintenir un substrat devant être poli selon l'une des revendications 1 à 3,
**caractérisé en ce que**
une partie de ladite tête de maintien de substrat (17A, 17C) dans laquelle l'autre extrémité du passage de fourniture de fluide (20A, 20C) est formée sous forme d'une surface plate, et le dispositif comprend en outre :
un moyen destiné à fixer une distance (tₐ,t_{c}) entre la surface plate et le substrat (13) devant être poli qui est disposé sur le patin de polissage (12) à une valeur supérieure ou égale à 1/1000 du diamètre du substrat (13) devant être poli.

5. Dispositif destiné à maintenir un substrat devant être poli selon l'une des revendications précédentes,
**caractérisé en ce que**
l'élément d'étanchéité annulaire (18A, 18C) est composé d'un matériau élastique.

6. Procédé de polissage d'un substrat devant être poli en appuyant le substrat (13) contre un patin de polissage (12), le procédé comprenant les étapes suivantes :
une première étape consistant à soulever et maintenir le substrat devant être poli par aspiration au moyen d'une tête de maintien de substrat de façon à transporter le substrat maintenu vers une position au-dessus dudit patin de polissage,
une seconde étape consistant à libérer le substrat transporté vers la position au-dessus dudit patin de polissage à partir de ladite tête de maintien de substrat de façon à disposer le substrat sur ledit patin de polissage,
une troisième étape consistant à fournir un fluide sous pression à un espace (21A) défini par :
- une tête de maintien de substrat (17A) qui peut se déplacer en direction du patin de polissage (12) et à l'écart de celui-ci, et qui comporte un élément de guidage (19A) sous la forme d'un anneau qui est disposé sur ladite tête de maintien de substrat (17A) afin de maintenir le substrat (13) devant être poli qui est disposé sur le patin de polissage (12) dans une position donnée et un passage de fourniture de fluide (20A) qui permet à un fluide sous pression d'être fourni depuis une première extrémité du passage de fourniture de fluide et de s'écouler vers l'extérieur depuis l'autre extrémité du passage de fourniture de fluide (20A),
- un élément d'étanchéité annulaire (18A) fixé à une partie de la tête de maintien de substrat (17A) qui entoure l'autre extrémité du passage de fourniture de fluide (20A), et
- le substrat (13) devant être poli,
une quatrième étape destinée à appliquer une force de pression prédéterminée sur la tête de maintien de substrat (17A) afin d'appuyer la tête de maintien de substrat contre le patin de polissage (12),
une cinquième étape consistant à appuyer le substrat (13) devant être poli contre le patin de polissage (12) sous la pression du fluide sous pression fourni depuis l'autre extrémité du passage de fourniture de fluide (20A) à l'espace (21A),
de telle sorte que le fluide sous pression repousse vers le haut l'élément d'étanchéité annulaire (18A) et la tête de maintien de substrat (17A) et s'écoule vers l'extérieur dudit espace (21A) par l'espace ainsi généré entre l'élément d'étanchéité annulaire (18A) et le substrat (13), si la pression du fluide sous pression dépasse la force de pression appliquée sur la tête de maintien de substrat (17A).

7. Procédé de polissage d'un substrat devant être poli selon la revendication 6,
**caractérisé en ce que**
la pression par surface élémentaire du fluide sous pression fourni à l'espace (21A) est plus grande que la pression obtenue en divisant la force de pression donnée par l'aire de la surface du substrat (13) devant être poli.

8. Procédé de polissage d'un substrat devant être poli selon la revendication 7,
**caractérisé en ce que**
la pression par surface élémentaire du fluide sous pression fourni à l'espace est toute valeur quelconque dans une plage de 1,1 à 2,0 fois la pression obtenue en divisant la force de pression donnée par l'aire de la surface du substrat (13) devant être poli.

9. Procédé de polissage d'un substrat devant être poli en appuyant le surface (13) contre un patin de polissage (12), le procédé comprenant les étapes suivantes :
une première étape destinée à soulever et maintenir le substrat devant être poli par aspiration au moyen d'une tête de maintien de substrat de manière à transporter le substrat maintenu vers une position au-dessus dudit patin de polissage,
une seconde étape consistant à libérer le substrat transporté vers la position au-dessus dudit patin de polissage depuis ladite tête de maintien de substrat de façon à disposer le substrat sur ledit patin de polissage,
une troisième étape consistant à fournir un fluide sous pression à un espace (21C) défini par :
- une tête de maintien de substrat (17C) qui peut se déplacer en direction du patin de polissage (12) et à l'écart de celui-ci et qui comporte un élément de guidage (19C) sous la forme d'un anneau qui est disposé sur ladite tête de maintien de substrat (17C) afin de maintenir le substrat (13) devant être poli qui est disposé sur le patin de polissage (12) dans une position donnée et un passage de fourniture de fluide (20C) qui permet à un fluide sous pression d'être fourni depuis une première extrémité du passage de fourniture de fluide (20C) et de s'écouler vers l'extérieur depuis l'autre extrémité du passage de fourniture de fluide (29C),
- un élément d'étanchéité annulaire (18C) qui entoure l'autre extrémité du passage de fourniture de fluide (20C) et est prévu mobile verticalement à l'intérieur dudit élément de guidage (19C), et
- le substrat (13) devant être poli,
une quatrième étape consistant à appliquer une force de pression prédéterminée sur la tête de maintien de substrat (17C) afin d'appuyer la tête de maintien de substrat contre le patin de polissage (12), et
une cinquième étape consistant à appuyer le substrat (13) devant être poli contre le patin de polissage (12) sous la pression du fluide sous pression fourni depuis l'autre extrémité du passage de fourniture de fluide (20C) à l'espace (21C), et déplacer l'élément d'étanchéité (18C) en direction du substrat (13) devant être poli de sorte que la partie périphérique du substrat (13) devant être poli est davantage appuyée contre le patin de polissage (12).

10. Procédé de polissage d'un substrat devant être poli selon la revendication 6 ou 9,
**caractérisé en ce que**
une partie de la tête de maintien de substrat (17A, 17C) qui maintient le substrat (13) est réalisée sous forme d'une surface plate, et
la troisième étape comprend l'étape consistant à maintenir une distance (tₐ,t_{c}) entre la surface plate et le substrat (13) devant être poli disposé sur le patin de polissage (12) à une valeur supérieure ou égale à 1/1000 du diamètre du substrat (13) deva1nt être poli.
